# EUROPEAN PATENT APPLICATION

(11) **EP 4 468 362 A1**
(43) Date of publication of application: **27.11.2024**
(21) Application number: 23174813.8
(22) Date of filing: 23.05.2023
(51) Int. Cl.: H01L 29/06, H01L 29/40, H01L 29/78, H01L 21/336

(54) **SEMICONDUCTOR DEVICE AND METHOD FOR FABRICATING A SEMICONDUCTOR DEVICE**

(71) Applicant: Infineon Technologies Austria AG, 9500 Villach (AT)
(72) Inventor: SIEMIENIEC, Ralf, 9500 Villach (AT); LAFORET, David, 9500 Villach (AT)
(74) Representative: JENSEN & SON

(57) **Abstract**

In an embodiment, a semiconductor device is provided that comprises an active area and an edge termination region laterally surrounding the active area. The active area comprises a plurality of active transistor cells. The edge termination region comprises one or more inactive cells, each inactive cell comprising a first columnar trench and a first termination mesa arranged adjacent to the first columnar trench. Each first columnar trench comprises a base, a side wall, a field plate, and a field dielectric arranged on the base and the side wall and surrounding the field plate. Each first termination mesa comprises a drift region of a first conductivity type and a body region of a second conductivity type arranged above the drift region. Each field dielectric of the first columnar trenches has a first thickness in an upper region of the field plate and a second thickness in a lower region of the field plate, the first thickness being smaller than the second thickness.

## Description

### BACKGROUND

Transistor devices used in power electronic applications are often fabricated with silicon (Si) semiconductor materials. Common transistor devices for power applications include Si CoolMOSO, Si Power MOSFETs and Si Insulated Gate Bipolar Transistors (IGBTs).

A transistor device for power applications may be based on the charge compensation principle and may include an active cell field including a plurality of trenches, each including a field plate for charge compensation. In some designs, the trenches and the mesas that are formed between adjacent trenches each have an elongate striped structure. In some other designs, the trenches have a columnar needle-like shape. Typically, the active cell field of the transistor device is laterally surrounded by an edge termination structure which may be helpful to avoid breakdown of the semiconductor device due to edge effects.

Avalanche breakdown is the phenomenon of current multiplication when a semiconductor device is subject to high electric fields. In the avalanche state, a high amount of power may be dissipated in the transistor device which may finally result in a destruction due to overheating if the avalanche current prevails longer than the time it takes to reach the thermal limit to overheat the transistor device. In order to prevent damage to the transistor device, it may be beneficial that the avalanche breakdown occur over a large area, thereby reducing the avalanche current density.

Discontinuities at the edges of semiconductor devices may create locally large electric fields, tending to produce avalanche breakdown preferentially at the edge of the device instead of uniformly distributed over the entire active area of the device. Edge termination structures may be useful to remove or smooth the discontinuities at the edge, thereby reducing the otherwise large fields at that location.

Avalanche breakdown can occur in the cell field. If the voltage required to reach breakdown electric field is lower for one device region, e.g. in a group of cells, than for others, the critical temperature will be reached more easily causing the device to fail in one specific area.

Further improvements would be desirable to further improve the performance of transistor devices, including MOSFET devices, to achieve improved avalanche robustness and a low on-state resistance.

### SUMMARY

According to the invention, in an embodiment, a semiconductor device is provided that comprises an active area and an edge termination region laterally surrounding the active area. The active area comprises a plurality of active transistor cells. The edge termination region comprises a transition region laterally surrounding the active region. The transition region comprises one or more inactive cells, each inactive cell comprising a first columnar trench and a first termination mesa arranged adjacent to the first columnar trench. Each first columnar trench comprises a base, a side wall, a field plate, and a field dielectric arranged on the base and the side wall and surrounding the field plate. Each first termination mesa comprises a drift region of a first conductivity type and a body region of a second conductivity type arranged above the drift region. Each field dielectric of the first columnar trenches has a first thickness in an upper region of the field plate and a second thickness in a lower region of the field plate, the second thickness being greater than the first thickness.

According to the invention, in an embodiment, a method for fabricating a semiconductor device. The method comprises forming a plurality of columnar trenches in a first major surface of a semiconductor substrate having a first conductivity type, the columnar trenches being arranged in an array of offset rows and each having a base and a side wall extending form the base to the first major surface, lining the base and side wall of the columnar trenches with a field dielectric, inserting conductive material into the columnar trenches, whilst covering a second subset of the plurality of columnar trenches that lies laterally outboard of a first subset of the plurality of columnar trenches, in the first subset of trenches: removing an upper portion of the conductive member from an upper portion of the columnar trenches and exposing the field dielectric arranged on the side wall; removing a portion of the exposed field dielectric and reducing the thickness of the exposed field dielectric arranged on the side wall of the upper portion of the columnar trenches; inserting conductive material into the columnar trench and filling the upper portion of the trench with the conductive material, implanting dopants of a second conductivity type into a first predetermined area of the first major surface to form a body region, wherein the second subset of the plurality of columnar trenches is positioned laterally outboard of the first predetermined area and the first subset of the plurality of columnar trenches is positioned laterally within the first predetermined area and implanting dopants of the first conductive type into a second predetermined area that is smaller than the first predetermined area.

Those skilled in the art will recognize additional features and advantages upon reading the following detailed description, and upon viewing the accompanying drawings.

### BRIEF DESCRIPTION

The elements of the drawings are not necessarily to scale relative to each other. Like reference numerals designate corresponding similar parts. The features of the various illustrated embodiments can be combined unless they exclude each other. Exemplary embodiments are depicted in the drawings and are detailed in the description which follows.
Figure 1A illustrates a schematic top view of a semiconductor device according to an embodiment and figure 1B illustrates a cross-sectional view of a portion of the semiconductor device.
Figure 2, which includes figures 2A and 2B, illustrates cross-sectional views of columnar trench according to various embodiments.
Figure 3A illustrates a schematic top view of a portion of a semiconductor according to an embodiment.
Figure 3B illustrates a schematic top view of a portion of a semiconductor according to an embodiment.
Figure 4A illustrates a schematic top view and figure 4B a cross-sectional view of a semiconductor device with an active area and an edge termination region according to an embodiment.
Figure 5A illustrates a schematic top view and figure 5B a cross-sectional view of a semiconductor device with an active area and an edge termination region according to an embodiment.
Figure 6A illustrates a schematic top view, figure 6B a cross-sectional view of a semiconductor device with an active area and an edge termination region according to an embodiment, Figure 6C a schematic top view of a semiconductor device with an active area and an edge termination region according to an embodiment, figure 6D illustrates an enlarged view of figure 6C and figure 6E a cross-sectional view of figure 6C.
Figure 7, which includes figures 7A to 7D, illustrates a method for fabricating a doped region in a semiconductor device.
Figure 8, which includes figures 8A to 8G, illustrates a method for fabricating a field dielectric having a stepped profile in a columnar trench.

### DETAILED DESCRIPTION

In the following detailed description, reference is made to the accompanying drawings, which form a part hereof, and in which is shown by way of illustration specific embodiments in which the invention may be practiced. In this regard, directional terminology, such as "top", "bottom", "front", "back", "leading", "trailing", etc., is used with reference to the orientation of the figure(s) being described. Because components of the embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, thereof, is not to be taken in a limiting sense, and the scope of the present invention is defined by the appended claims.

A number of exemplary embodiments will be explained below. In this case, identical structural features are identified by identical or similar reference symbols in the figures. In the context of the present description, "lateral" or "lateral direction" should be understood to mean a direction or extent that runs generally parallel to the lateral extent of a semiconductor material or semiconductor carrier. The lateral direction thus extends generally parallel to these surfaces or sides. In contrast thereto, the term "vertical" or "vertical direction" is understood to mean a direction that runs generally perpendicular to these surfaces or sides and thus to the lateral direction. The vertical direction therefore runs in the thickness direction of the semiconductor material or semiconductor carrier.

As employed in this specification, when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present.

As employed in this specification, when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

As used herein, various device types and/or doped semiconductor regions may be identified as being of n type or p type, but this is merely for convenience of description and not intended to be limiting, and such identification may be replaced by the more general description of being of a "first conductivity type" or a "second, opposite conductivity type" where the first type may be either n or p type and the second type then is either p or n type.

The Figures illustrate relative doping concentrations by indicating "-" or "+" next to the doping type "n" or "p". For example, "n-" means a doping concentration which is lower than the doping concentration of an "n"-doping region while an "n⁺"-doping region has a higher doping concentration than an "n"-doping region. Doping regions of the same relative doping concentration do not necessarily have the same absolute doping concentration. For example, two different "n"-doping regions may have the same or different absolute doping concentrations.

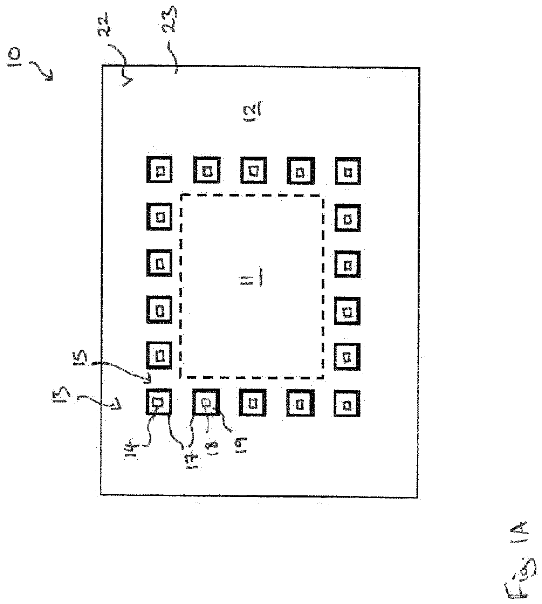

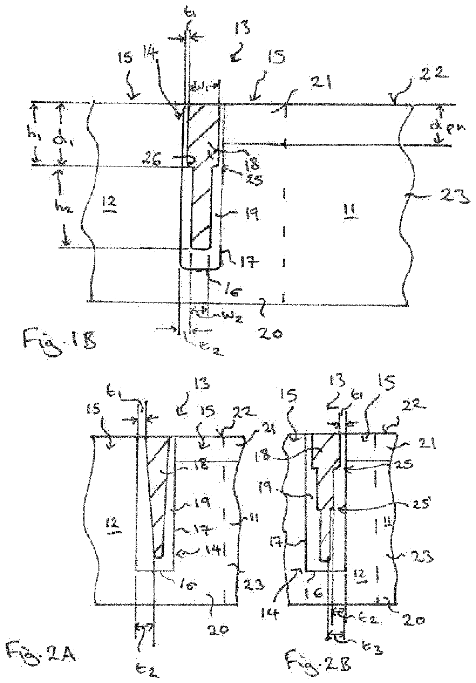

Figure 1 illustrates a semiconductor device 10, whereby figure 1A illustrates a top view and figure 1B a cross-sectional view of a portion of the semiconductor device 10. The semiconductor device 10 includes an active area 11 and an edge termination region 12, which laterally surrounds the active area 11, which are positioned in a semiconductor substrate 23 having a first major surface 22. The semiconductor substrate 23 may be formed of silicon, for example monocrystalline silicon or an epitaxial silicon layer.

The semiconductor device 10 comprises at least one columnar trench 14. A columnar trench, which may also be called a needle-shaped trench or needle trench or spicular trench, has a small or narrow circumference or width in proportion to its height / depth in the substrate. For example, the depth is at least twice the width.

One or more of these columnar trenches 14 may be arranged in the edge termination region 12 and/or in the active region 11. The columnar trench 14 may form part of an inactive cell when it is positioned in the edge termination region 12. When the columnar trench is positioned in the active region it may form part of a transistor cell. For example, the columnar trench 14 may not be part of a transistor cell.

The active area 11 comprises at least one active semiconductor device, for example at least one transistor device that comprises a plurality of active transistor cells which may be electrically connected to one another in parallel to switch a load. In figure 1 the transistor device in the active area 11 is not shown and the columnar trench 14 is located in the edge termination region 12. The edge termination region 12 comprises one or more inactive cells 13, each inactive cell 13 comprising one columnar trench 14 and a termination mesa 15 arranged adjacent to the first columnar trench 14.

In figure 1A, the columnar trenches 14 are illustrated as having a square lateral form in top view. However, the columnar trench 14 may have other lateral forms in top view. For example, the columnar or needle trench 14 may have an octagonal, circular, or hexagonal shape in plan view.

As can be seen in the cross-sectional view of figure 1B, the columnar trench 14 comprises a base 16 and a sidewall 17. The side wall 17 extends from the base 16 to the first major surface 22 of the semiconductor substrate 23. The columnar trench 14 further comprises a field plate 18 and a field dielectric 19. The field dielectric 19 is arranged on the base 16 and sidewall 17 of the columnar first trench 14 and surrounds the field plate 18 which is located in the trench. The field plate 18 is electrically conductive and may be formed of polysilicon, for example. The field plate 18 may extend to the first major surface 22 and have an upper surface that is coplanar with the first major surface 22 of the semiconductor substrate 23. The field dielectric 19 may include one or more sublayers having the same or differing compositions. The field dielectric 19 may be SiOₓ, for example.

In embodiments in which the columnar trench 14 is circular in plan view, the columnar trench 14 has a single side wall 17. If the columnar trench 14 is square in plan view, as shown in figure 1A, the side wall 17 is divided into four side wall sections arranged substantially perpendicularly to one another. Similarly, if the columnar trench 14 is hexagonal in plan view, the side wall 17 has six side wall sections etc.

A plurality of the columnar trenches 14 may be arranged in a regular array, such as a square grid array of rows and columns, or an array of offset rows (such as a hexagonal array), in which the spacing or pitch between neighboring ones of the columnar trenches 14 is substantially the same throughout the array. In some embodiments, such as that illustrated in figure 1A, a plurality of columnar trenches 14 may be arranged in a ring in the edge termination region 12. The ring laterally surrounds the active area 11.

Referring to figure 1B, in some embodiments, the field dielectric 19 in the first columnar trench 14 has a first thickness t1 on the side wall 17 in an upper portion of the trench 14 and a second thickness t2 on the side wall 17 in the lower portion of the trench 14. The second thickness t2 of the field dielectric 19 in a lower portion of trench 14 the trench is greater than the thickness t1 in the upper portion of the trench 14. As the field plate 18 and the field dielectric 19 together fill the columnar trench 14, the field plate 18 has a larger width w1 in the upper portion of the trench 14 than its width w2 in the lower portion of the trench 14.

Referring to figure 1B, in some embodiments, the field dielectric 19 comprises an abrupt transition from the first to the second thickness that forms a step 25 so that the field dielectric 19 can be considered to have a stepped shape. In some embodiments, the field dielectric 19 has the smaller thickness t1 over a first height h1 of the columnar trench 14 in the upper portion and the larger thickness t2 over a second height h2 of the columnar trench 14 in the lower portion.

In some embodiments, the thickness t₁ ≤ 1.15 times the thickness t₂ and consequently the thickness t₁ is greater than typical process variations. In some embodiments, the difference is greater so that t₁ ≤ 1.2 t₂ or t1 ≤ 1.5 t₂.

The field plate 18 may also have an abrupt transition between a larger width w1 in the upper portion of the trench 14 and a smaller width w2 towards the lower portion of the trench 14. The field plate 18 can be considered to have a step 26 in its outer surface 27 corresponding to the step 25 formed in the field dielectric 19. The field plate 18 can be considered to have a T-shape in cross-section.

The termination mesa 15 of each inactive cell 13 is formed by the region of the semiconductor substrate 23 that laterally surrounds the columnar trench 14 of that inactive cell 13. The structure of the mesa 15 may differ, for example depending on the position of the columnar trench 14 and its associated mesa 15 within the edge termination region 12. In some embodiments, for example as illustrated in figure 1B, each termination mesa 15 comprises a drift region 20 of the first conductivity type, for example n-type. One or more of the termination mesas 15, further comprises a body region 21 of the second conductivity type, for example p type if the drift region is n-type. For example, the termination mesa 15 illustrated in the right-hand portion of the edge termination region 12 that adjoins the active region 11 includes a body region 21. The body region 21 is arranged above the drift region 20 and may form a pn junction with the drift region 20. In some embodiments, in the termination mesa 15, the body region 21 extends to the first major surface 22 of the semiconductor substrate 23 of the semiconductor device 10. In some embodiments, for example as illustrated in the left-hand portion of the edge termination region 12 of figure 1B, the inactive cell 13 comprises a termination mesa 15 without a body region so that the drift region 20 extends to the first major surface 22 of the semiconductor substrate.

In some embodiments, such as those illustrated in figures 1B, 2A and 2B, the body region 21 is positioned laterally adjacent only a portion of the periphery of the columnar trench 14 and the drift region 20 is arranged laterally adjacent the remainder of the periphery of the columnar trench 14. In other embodiments, the body region 21 laterally surrounds the entire columnar trench 14., In other embodiments, the drift region 20 laterally surrounds the entire columnar trench 14.

In some embodiments, the field dielectric 19 has the thickness t₁ in a first region of the side wall 17 that is contiguous to the body region 21 and the thickness t₂ in a second region of the side wall 17 that is contiguous to the drift region 20. The step 25 is located at a depth d₁ from the first major surface 22 of the semiconductor substrate 23 and the pn junction formed between the body region 21 and the drift region 20 has a depth dₚₙ from the first major surface of the semiconductor substrate, wherein d₁ > dₚₙ. The step 25 may be positioned laterally adjacent the drift region 20.

In some embodiments, the one or more first inactive transistor cells 13 of figure 1B are directly adjacent to one or more of the plurality of active transistor cells in the active region 11. The region of the edge termination region 12 in which the first columnar trenches 14 are located, can be referred to as a transition region.

An active transistor cell may comprise a columnar trench that has the same structure as columnar trench 14, but with an active mesa. In the active transistor cell, the active mesa comprises the drift region 20, the body region 21 on the drift region 20 and a source region of the first conductivity type on the body region 21 (not shown in Fig. 1B). The active transistor cells are not illustrated in figures 1A 1B. In the active area, a gate trench comprising a gate electrode is located in the active mesa. A drain region 58 of the first conductivity type is arranged on a second major surface of the semiconductor substrate, the second major surface opposing the first major surface.

The columnar trench of the active transistor cells may have the form illustrated in and described with reference to figures 1B and 2. The columnar trenches of the active transistor cells and the columnar trenches 14 of the inactive cells 13 may form an array with a common spacing or pitch between adjacent ones of the columnar trenches. The inactive cells 13 are distinguishable from the active transistor cells in that the active transistor cells include a source region on the body region and the inactive cells are without a source region. In the inactive cells 13, the body region 21 may extend to the first major surface of the semiconductor substrate. At least one of the inactive cells 13 is arranged directly adjacent, i.e. is the immediate neighbour of, an active cell. For example, one or more rings of inactive cells 13 may laterally surround the active area 11 as shown in figure 1A.

The field dielectric 19 and consequently the field plate 18 within the columnar trenches 14 may have other forms as an alternative to the one shown in Fig. 1B. Figures 2A and 2B illustrate two embodiments of a columnar trench 14 that may be located in the edge termination region 12 as part of an inactive cell 13 or in the active area 11 as part of an active transistor cell. Referring to figure 2A, the field plate 18 may have a tapering structure such that its width decreases from the top of the trench 14 towards the base 16 of the trench 16. The field dielectric 19 has the opposite structure such that the thickness of the field dielectric 19 on the side wall 17 continuously increases in a direction from the first major surface 22 towards the base 16 of the trench 14. The field dielectric has a thickness t1 on the side wall 17 at the first major surface 22 and decreases continuously to a thickness t2 on the side wall 17 at a portion laterally adjacent to the lower surface of the field plate 18, whereby t1 < t2.

Referring to figure 2B, the field dielectric 19 may also have more than one step 25. Figure 2B illustrates an embodiment in which the field dielectric 19 has two steps 25, 25' such it has three different thicknesses on the side wall 17 of the columnar trench 14. The thickness of the field dielectric 19 increases stepwise incrementally from the first major surface 22 towards the base 16 of the columnar trench 14. In the upper portion of the side wall 17, the field dielectric has a thickness t1, in the middle portion a thickness t2 and in the third portion a thickness t3, whereby t1 < t2 < t3. The side face of the field plate 18 has two steps 26, 26' such it has three different widths and such that the width of the field plate 18 decreases stepwise from the first major surface 22 towards the base 16 of the columnar trench 14.

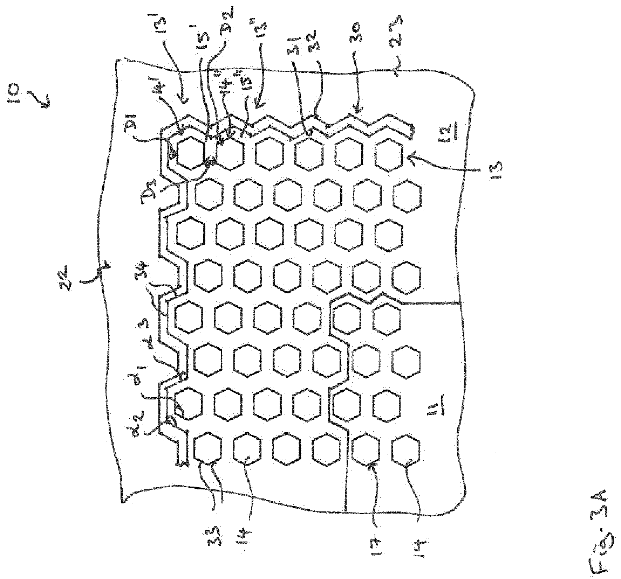

Figure 3A illustrates a top view of a semiconductor device 10 according to an embodiment. The semiconductor device 10 comprises an active area 11 and an edge termination region 12 which laterally surrounds the active area 11. The active area 11 comprises a plurality of transistor cells (e.g., with columnar trenches 14 as shown in Figs. 1B, 2A and 2B). The edge termination region 12 comprises a termination trench 30 and a plurality of inactive cells 13, each comprising a columnar trench 14 and a termination mesa 15 which is formed by the region of the semiconductor substrate that laterally surrounds the columnar trench (as shown in Figs. 1B, 2A and 2B). A first one 13' of the inactive cells 13 comprises a first columnar trench 14' and a first termination mesa 15' and a second one 13" of the inactive cells 13 comprises a second columnar trench 14" and a second termination mesa 15". In this embodiment, the columnar trenches 14 have a hexagonal form in plan view. In other embodiments, the columnar trenches 14 may have different lateral forms, for example octagonal, square or circular. The first and second inactive cells 13', 13" are arranged directly adjacent to one another and directly adjacent to the termination trench 30. The termination trench 30 is completely filled with dielectric, for example dielectric material 37, e.g. SiOₓ.

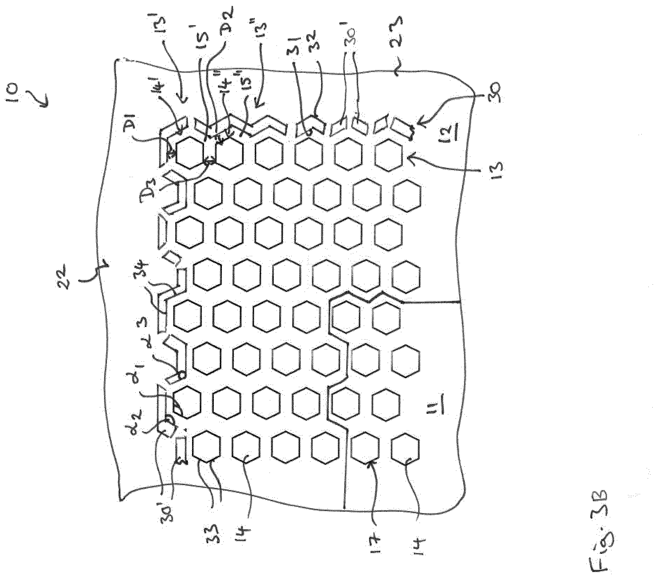

The first and second columnar trenches 14, 14' are part of a plurality of columnar trenches 14 which are arranged in an array comprising offset rows. In the embodiment illustrated in figure 3, the spacing or distance parallel to the first major surface 12 D3 between the columnar trenches of the array is substantially equal such that the columnar trenches 14 are also arranged in a hexagonal array. The shortest distance D1 between the termination trench 30 and the first columnar trench 14 is the same as the shortest distance D2 between the termination trench 30 and the second columnar trench 14'. The shortest distance D3 between the first columnar trench 14 and the second columnar trench 14' of the array is larger than the shortest distance between the termination trench 30 and the first columnar trench 14. In other words, D3 is greater than D1 and consequently D3 is also greater than D2.

In some embodiments, such as that illustrated in figure 3A, the termination trench 30 is a continuous trench that laterally uninterruptedly and continuously surrounds the active area 11. In other embodiments, such as that illustrated in figure 3B, the termination trench 30 is an interrupted trench and comprises a plurality of separate termination trench sections 30' which are arranged in a ring with the separate trench sections 30' being spaced part by portions of the semiconductor substrate 23. In both designs, the termination trench 30 or plurality of termination trench sections 30' is/are filed with dielectric material 37, for example SiOx, and is free of conductive material. The termination trench 30 comprises an inner side wall section 31 which faces towards the active area 11 and an outer sidewall section 32 which faces towards the periphery of the semiconductor substrate 23 and opposes the inner side wall section 31. The inner and outer sidewall sections 31, 32 extend substantially parallel to one another. In some embodiments, the spacing between the inner sidewall 31 of the termination trench 30 and the individual ones of the columnar trenches 14 that are arranged at the periphery of the array is substantially uniform. In top view, the continuous termination trench 30 has an undulating or wavy form, as shown in Figure 3A, or the ring shape of the plurality of trench sections 30' has an undulating or wavy form in top view, as shown in figure 3B.

The columnar trenches 14 each have a plurality of sidewall sections 33, in this embodiment, six sidewall sections, whereby adjoining ones of the sections 33 have an internal angle α1 which is greater than 90°. In the case of a hexagonal columnar trench 14, the angle α1 is 120°. In order that the spacing between the inner wall 31 and the sidewall sections 33 of the columnar trenches 14 is substantially the same, the inner sidewall 31 and the outer sidewall 32 of the termination trench 30 have a plurality of subsections 34. Adjoining sidewall subsections 34 of the inner side wall 31 of the termination trench 30 which are arranged adjacent adjoining sidewall sections 33 of the same columnar trench 14, form an external angle α2 which is substantially the same as α1. Adjoining sidewall sub sections 34 of the inner side wall section 31 of the termination trench 30 which are arranged adjacent neighbouring ones of the columnar trenches, form an internal angle α3 which is substantially the same as α1.

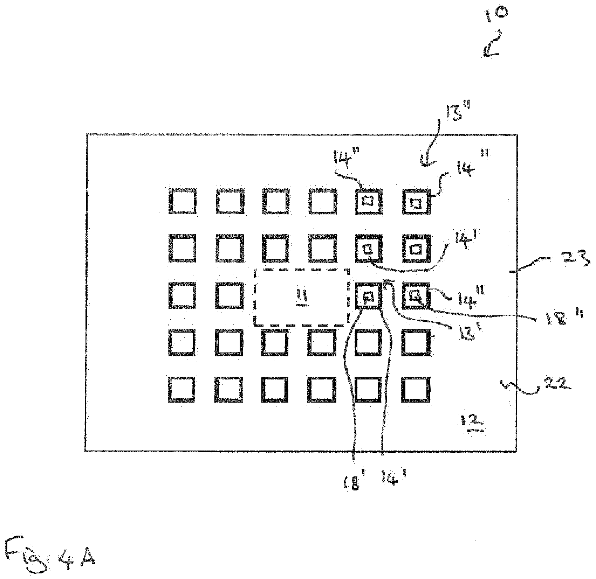

In some embodiments, the edge termination region 12 includes a plurality of subregions which concentrically surround the active area 11 and which have different structures. For example, the edge termination region 12 may have the subregions described with reference to figures 4A to 6C. In some embodiments, the edge termination region 12 comprises a transition region 50 which laterally surrounds the active area 11, and inner termination region 51 that laterally surrounds the transition region 50, an intermediate termination region 52 laterally surrounds the inner termination region 51 and an outer termination region 53 that laterally surround the intermediate termination region 52. In an embodiment, the termination trench 30 and the first and second inactive cells 13, 13' are arranged in the intermediate termination region 52. The outer termination region 53 may be devoid of columnar trenches.

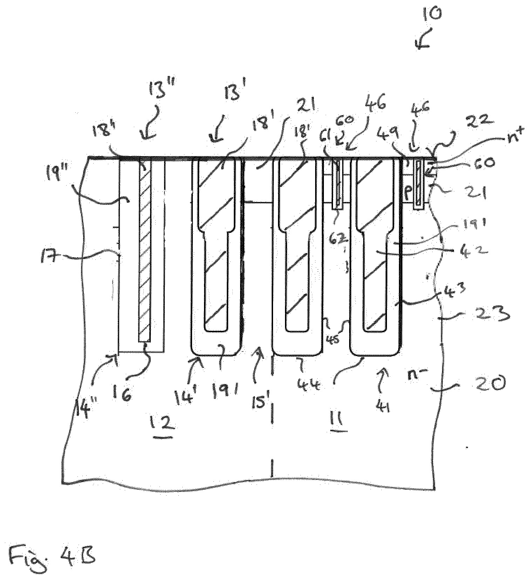

Figure 4A illustrates a top view and figure 4B a cross-sectional view of a semiconductor device 10 according to an embodiment. The semiconductor device 10 comprises an active area 11 (not drawn to scale) including a plurality of active transistor cells and an edge termination region 12 formed in a semiconductor substrate 23. The edge termination region 12 laterally surrounds the active area 11 on all lateral sides and comprises a plurality of inactive cells 13. The inactive cells 13 in the edge termination region 12 each comprise a columnar trench 14 comprising a field plate 18 and a field dielectric 19 having a profile. The field dielectric 19 is arranged on the base 16 and sidewall 17 of the first columnar trench 14 and surrounds the first field plate 18. In this embodiment, the profile of the field dielectric 19 is different depending on the position of the columnar trench 14 within the edge termination region 12.

The edge termination region 12 comprises one or more first inactive cells 13', each comprising a columnar trench 14' which has a base, a sidewall 17, a first field plate 18' and a field dielectric 19 having a first profile 19'. The edge termination region 12 further includes one or more second inactive cells 13". Each of the second inactive cells 13" includes a columnar trench 14" comprising a base 16" and a sidewall 17", a second field plate 18" and a second dielectric profile 19". The first field dielectric structure 19' may have a different thickness profile from the second field dielectric structure 19".

The term "profile" and the term "thickness profile" of the field dielectric 19 are used herein to describe the thickness of the field dielectric 19 within the columnar trench 14 along a direction orthogonal to the first major surface 22, pointing to the base 16 of the trench 14. The cross-sections views of Figs. 1B, 2A and 2B show such profiles for the field dielectric 19. In these embodiments, the profile is non-uniform as the thickness of the field dielectric 19, measured in a direction parallel to the first major surface 22, varies in a direction orthogonal to the first major surface 22. The thickness of the field dielectric 19 is smaller in the upper portion of the trench 14, e.g. at the first major surface 22, than in the lower portion of the trench 14. The variation in the thickness is greater than that arising from processing variations.

In some embodiments, the active transistor cells 40 in the active area 11 each have a columnar trench 41 having a field plate 42 and a field dielectric 43 having the first field dielectric profile 19'.

In some embodiments, the second inactive cells 13" are closer to the edge of the semiconductor substrate 23 than the first inactive cells 13'. For example, one or more rows of first columnar trenches 14' with a first field dielectric structure 19' laterally surround the active area 11 and one or more rows of third columnar trenches 14" with a second field dielectric structure 19" laterally surround the first columnar trenches 14'. The structure of the field dielectric 19 in the columnar trenches 14 varies depending on the position of that columnar trench 14 within the edge termination region 12. The columnar trenches in the active area 11 and the columnar trenches 14', 14" in the edge termination region 12 may be arranged in an array that has the same spacing or pitch throughout the array. The array may be a square grid array, as shown in figure 4A, or include off set rows. In some embodiments, the outermost ones of the columnar trenches 14 of the array have a different field dielectric profile to the remainder of the columnar trenches 14 of the array.

Figure 4B illustrates a cross-sectional view of a portion of the active area 11 and edge termination region 12 in which the first and second field dielectric profiles 19', 19" can be seen. In some embodiments, the first field dielectric structure 19' of the first columnar trench 14 has a thickness that is greater on the lower portion of the sidewall 17 than on an upper portion of the sidewall 17. For example, the first field dielectric structure may be that shown in or described with reference to figures 1B, 2A and 2B. In contrast, the second dielectric structure 19" of the second columnar trench 14" has a thickness that is substantially uniform along the height of the side wall 17. Therefore, the inactive cells 13 of the edge termination region 12 are not the same throughout the edge termination region 12.

The active area 11 includes a plurality of transistor cells 40 that are electrically coupled in parallel to provide a transistor device for switching a load. The transistor device is a vertical field effect transistor device based on a charge compensation principle.

The semiconductor device 10 includes a semiconductor substrate 23 having a first surface 22, a second surface, which cannot be seen in the partial cross-sectional view of figure 4B, that opposes the first surface 22, and side faces extending between the first surface 22 and the second surface. The semiconductor substrate 23 may comprise silicon and may include a silicon epitaxial layer deposited on a substrate such as a single crystal silicon substrate. The first surface 22 can be referred to as the top surface and the second surface as the rear surface.

Each active transistor cell 40 comprises a columnar trench 41 and a mesa 46. The columnar trench 41 comprises a field plate 42 and a field dielectric 43 that lines the base 44 and side wall 45 of the columnar trench 41. The mesas 46 are formed by the regions of the semiconductor substrate 23 that are located between the columnar trenches 41. The columnar trench 41 have the same structure as the innermost columnar trench 14' of the edge termination region 12 so that the field dielectric 19' has a non-uniform thickness on the side wall 45. The field dielectric 19' may be thicker in the lower portion of the columnar trench 41 than in the upper portion. For example, the field dielectric 43 may have the structure and profile illustrated in or described with reference to figures 1B, 2A and 2B.

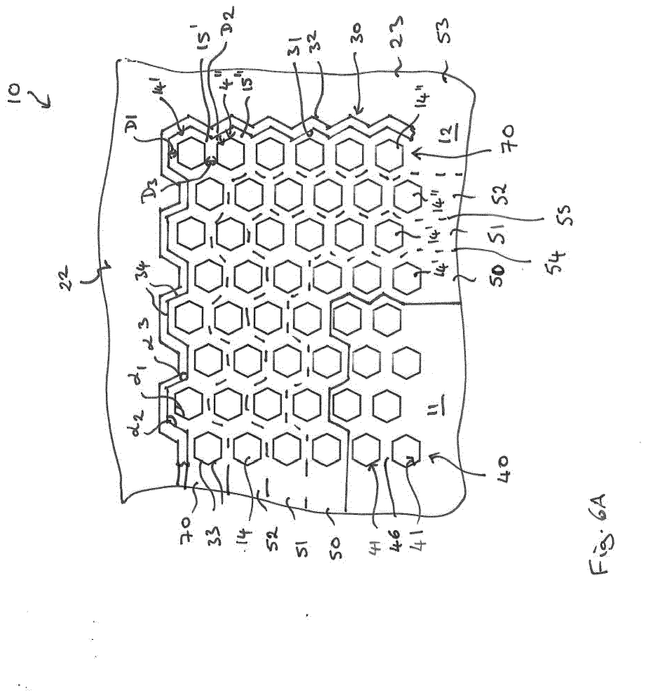

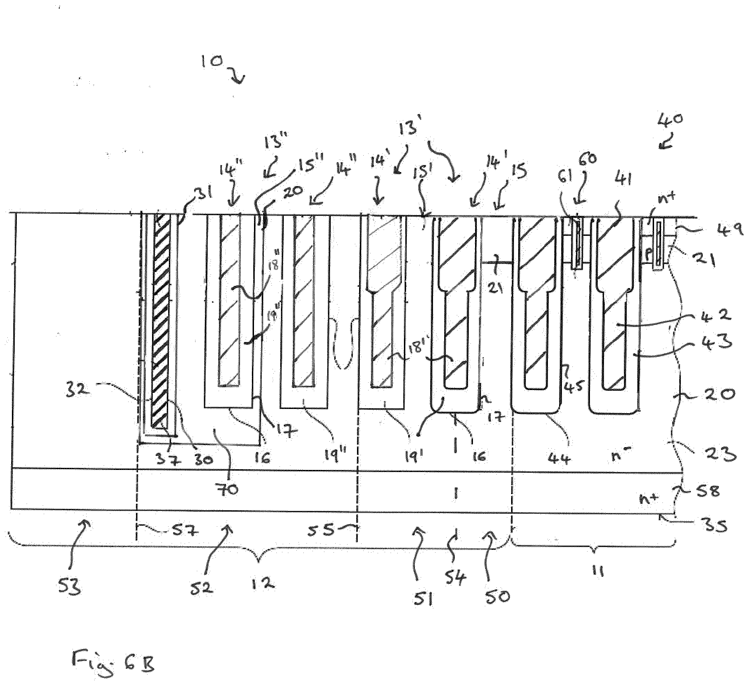

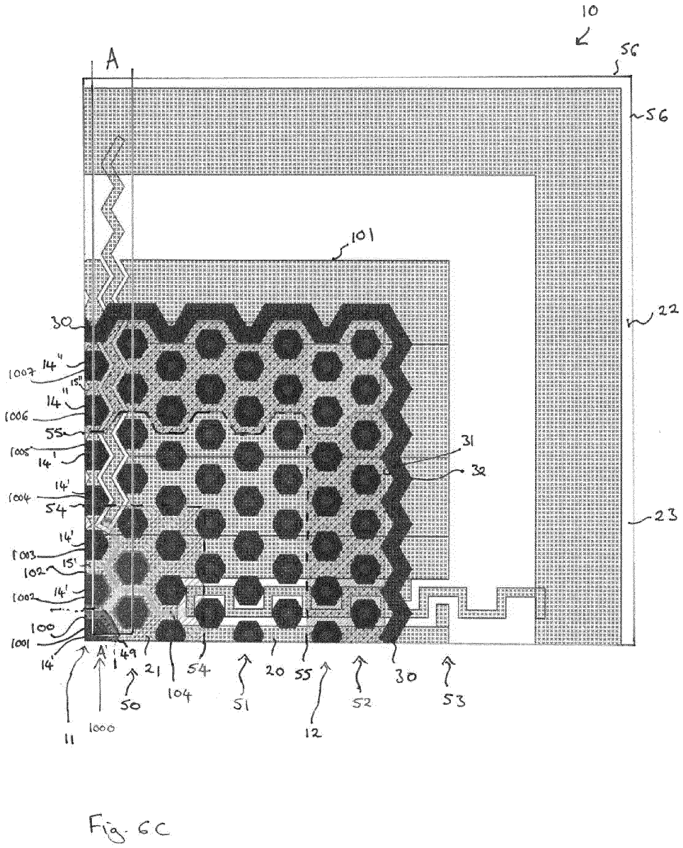

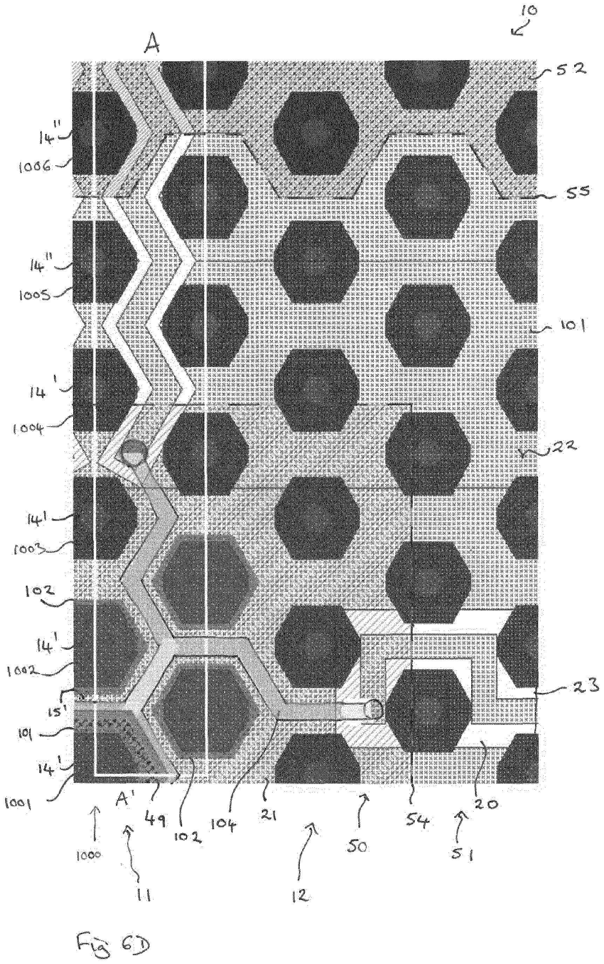

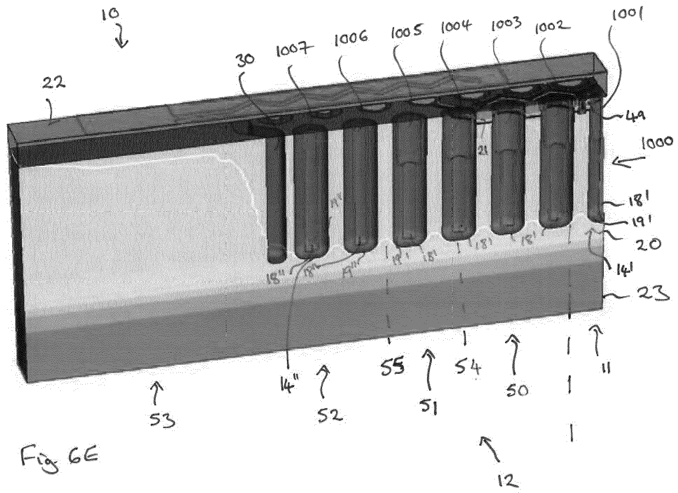

In the embodiment illustrated in figure 4A and 4B, the columnar trenches 14, 41 are arranged in a regular array, such as a regular square grid, for example of rows and columns in which the columnar trenches 14, 41 have the same pitch or spacing. In some embodiments, such as that illustrated in figures 3 or 6, the columnar trenches 19 are arranged in an array of staggered or shifted rows. The lateral form of each of the columnar trenches 14, 41 within the array having any form or pattern may be square, octagonal, round or hexagonal, for example. For example, the columnar trenches may have a lateral octagonal form in plan view and be arranged in staggered rows. The cross-sectional form of the columnar trenches 14, 41 is however the same irrespective of the lateral form of the trench and the type of array.

In some embodiments, the columnar trenches 14 of the inactive cells 13' that are arranged directly adjacent to the active area 11 may have the same structure as the columnar trenches 40 of the transistor cells 13 and comprise a first dielectric structure 19'.

In some embodiments, such as that illustrated in figure 4B, the first dielectric structure 19' has a stepped profile, e.g. as shown and described with reference to figures 1B and 2B, so that the thickness of the first dielectric structure 19' is smaller towards the top of the columnar trench 14 than towards the base 16. In other embodiments, the first dielectric structure may have a tapered form, e.g., as shown with reference to Figure 2A. The second Inactive cells 13" that are arranged laterally outwardly from the first inactive cells 13' comprise a columnar trench 14" having the second dielectric structure 19" in which the thickness of the field dielectric is substantially uniform along the entire height of the side wall 17. The first inactive cells 13' may be arranged in a transition region 50 and the second inactive cells 13" in an intermediate region 52 of the edge termination region 12.

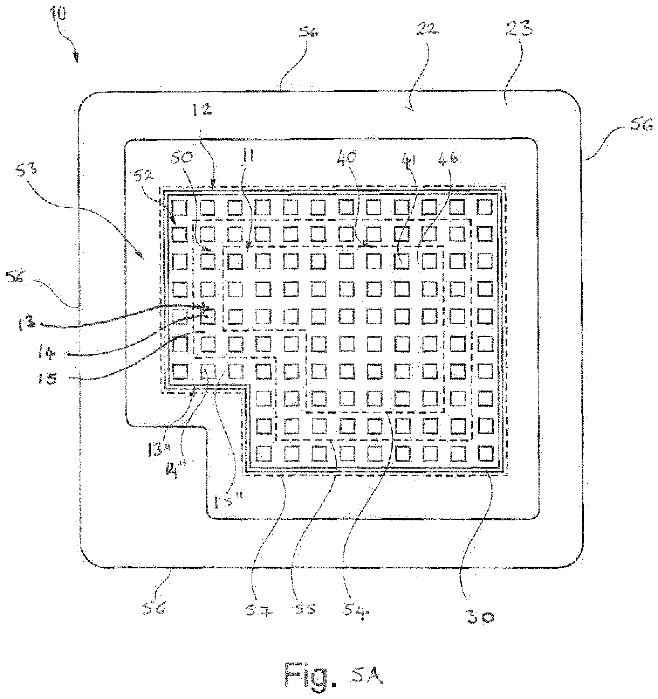

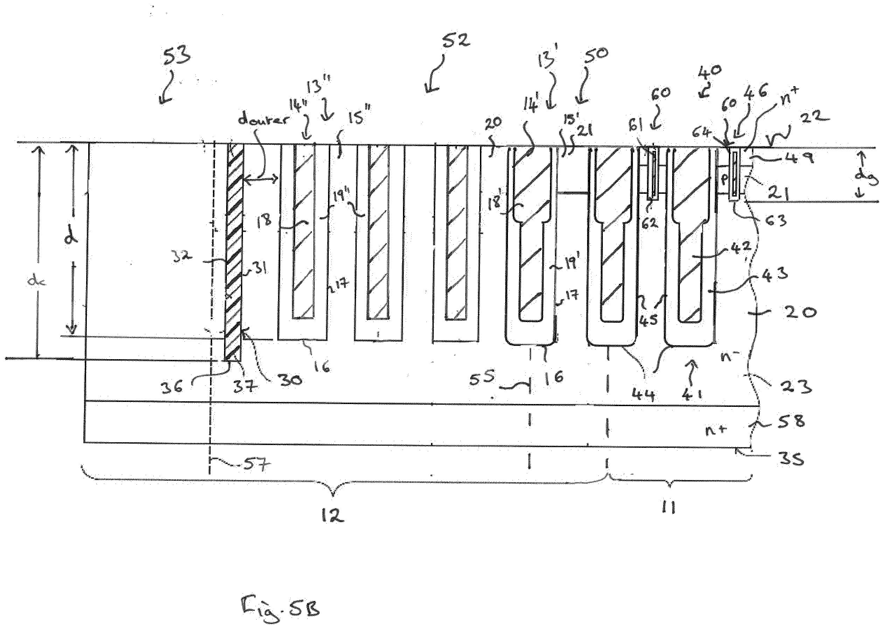

Figure 5A illustrates a plan view and Figure 5B a cross-sectional view of a semiconductor device 10 having an active area 11 and an edge termination region 12 that is subdivided into different regions which are arranged concentrically around the active area 11. Each of these regions is distinguishable by a different structure.

The active area 11 includes a plurality of transistor cells 40 that are electrically coupled in parallel to provide a transistor device for switching a load. The transistor device is a vertical field effect transistor device based on a charge compensation principle.

The semiconductor device 10 includes a semiconductor substrate 23 having a first surface 22, a second surface 35, which cannot be seen in the top view of figure 5A, that opposes the first surface 22, and side faces 56 extending between the first surface 22 and the second surface 35. The semiconductor substrate 23 may comprise silicon and may include a silicon epitaxial layer deposited on a substrate such as a single crystal silicon substrate. The first surface 22 can be referred to as the top surface and the second surface 35 as the rear surface.

The semiconductor device 10 includes the active area 11 which is laterally surrounded by an edge termination region 12 on all sides. The active area 11 includes a plurality of active transistor cells 40. Each active transistor cell 40 comprises a columnar trench 41 and a mesa 46. The columnar trench 41 comprises a field plate 42 and a field dielectric 43 that lines the base 44 and side wall 45 of the columnar trench 41. The mesas 46 are formed by the regions of the semiconductor substrate 23 that are located between the columnar trenches 41. The columnar trench 41 have the same structure as the columnar trenches 14' in the transition region 51 so that the field dielectric 19 has a non-uniform thickness on the side wall 45. The field dielectric may be thicker in the lower portion of the columnar trench 41 than in the upper portion. For example, the field dielectric 43 may have the structure illustrated in or described with reference to figures 1B, 2A and 2B.

In the embodiment illustrated in figure 5A, the columnar trenches 14, 41 are arranged in a regular array, such as a regular square grid, for example of rows and columns in which the columnar trenches 14, 41 have the same pitch or spacing. In some embodiments, such as that illustrated in figures 3 or 6, the columnar trenches 19 are arranged in an array of staggered or shifted rows. The lateral form of each of the columnar trenches 14, 41 within the array having any form or pattern may be square, octagonal, round or hexagonal, for example. For example, the columnar trenches may have a lateral octagonal form in plan view and be arranged in staggered rows. The cross-sectional form of the columnar trenches 14, 41 is however the same irrespective of the lateral form of the trench and the type of array.

In the embodiments of figure 5A and 5B, the edge termination region 12 comprises a transition region 50 which laterally surrounds the active region 11, an intermediate termination region 52 which laterally surrounds the transition region 50 and an outer termination region 53 that laterally surrounds the intermediate termination region 52. In some embodiments, an inner termination region 51 is positioned between the transition region 50 and the intermediate termination region 52.

The boundary between the transition region 50 and the intermediate termination region 52 is indicated by the dashed line 55 and the boundary between the intermediate termination region 52 and the outer termination region 53 is indicated by the dashed line 57.

The transistor device formed by the active transistor cells 40 and positioned in the active region 11 may be a vertical MOSFET device that comprises the field plates 42 for charge compensation. The source and gate of the MOSFET device may be positioned at the first surface 22 and the drain region 58 may be positioned at the second opposing surface 35 so that the drift path of the MOSFET device extends vertically and substantially perpendicular to the first surface 22 and the second surface 35.

Some MOSFET devices have a stripe design, i.e. the trenches 41 and the mesas 46 have an elongate strip form and are arranged alternatively so that a strip-like mesa 46 is defined by two adjacent strip-like trenches 41. However, some types of designs of MOSFET devices with a field plate for charge compensation, such as that illustrated in figures 5A and 5B, include columnar or needlelike trenches 41 so that the mesa 46 is formed by the material between the columnar trenches 41. The cross-sectional is the same for both stripe-like trenches 41 and columnar trenches 41.

A columnar field plate 42 is positioned in the columnar trenches 41 and is electrically insulated from the semiconductor substrate 23 by a dielectric material 43 that lines the sidewalls 33 and base 40 of the columnar trench 19. The columnar trench 41 is typically a deep trench containing the field-plate 42 in the center.

The field dielectric 43 comprises a stepped shape and has a first upper portion 47 positioned in the upper portion of the trench with a thickness t1 and a second lower portion 48 with a thickness t2 that is positioned in the lower portion of the trench 41, whereby t2 > t1.

A separate shallower gate trench 60 is positioned in the mesa 46. The gate electrode 61 of the transistor cell 40 is positioned in the gate trench 60 and is electrically insulated from the semiconductor substrate 23 by a gate dielectric 62 that lines the base 63 and side wall 64 of the gate trench 60. The gate trench 60 has an elongate form.

The gate trenches 60 interconnect to form a grid structure that laterally surrounds each columnar trench 41. The grid structure may be a square grid or a hexagonal or octagonal grid. The shape of the gate grid may follow the shape of the columnar trenches so that the spacing between the gate trenches 60 and the columnar trenches is substantially uniform.

In some embodiments, the gate trenches 60 do not interconnect to form a grid, but instead a plurality of separate gate trenches are provided, which extend across the first major surface in lines, which may be straight or zig-zag, e.g. meandering in top view. The meandering shape may follow the shape of the columnar trenches so that the spacing between the gate trenches 60 and the columnar trenches is substantially uniform. In some embodiments, the separate gate trenches and /or the gate grid are interrupted, i.e. discontinuous, to provide a plurality of discrete sections that are spaced apart from one another.

The transition region 50 and the inner edge termination region 52 of the edge termination region 12 comprise a plurality of inactive cells 13. Each inactive cell 13 comprises a columnar termination trench 14 and a termination mesa 15. The columnar termination trench 13 also comprises a field plate 18. The termination mesa 15 includes a drift region 20 of a first conductivity type.

In some embodiments, the edge termination region 12 further includes at least one termination trench 30 that is positioned in the outer termination region 53. The termination trench 30 may be a continuous trench that forms a single ring that continuously and uninterruptedly laterally surrounds the columnar termination trenches 14 and the inactive cells 13 or may comprise a plurality of sections 30' arranged in a ring that laterally surrounds the columnar termination trenches 14. The sections 30' are each elongate and have a length measured in a plane parallel to the first major surface 12 that is greater, i.e. at 1.5 times larger, than a width measured in a plane parallel to the first major surface 12. The termination trench 30or the plurality of sections 30' are filled with dielectric material 37. The plurality of sections 30' may be spaced apart by a portion of the semiconductor substrate 23 that has a width that may be less than the distance from the section 30' to the immediately adjacent columnar termination trench 14. The width of the semiconductor substrate 23 between the sections 30' of the termination trench 30 may alternatively be the same as or greater than the distance from the section 30' to the immediately adjacent columnar termination trench 14.

The columnar termination trenches 14 and the columnar trenches 41 of the active cells 40 are arranged in an array. The termination trench 30 laterally surrounds and is arranged at the periphery of this array, i.e. between the array and the side faces 56 of the semiconductor substrate 23. The termination trench 30 is free of electrically conductive material and does not include a field plate.

In some embodiments, the termination trench 30 is spaced apart from a laterally outermost one of the columnar termination trenches 14 by a distance dₒᵤₜₑᵣ. dₒᵤₜₑᵣ may be 50 nm ≤ dₒᵤₜₑᵣ ≤ 2 µm. The semiconductor substrate 23 typically has a cuboid form with substantially perpendicular substantially straight side faces 56 that intersect at corners. The distance dₒᵤₜₑᵣ is measured adjacent to the side faces 56 rather than at the corners.

In some embodiments, the lateral shape, pattern and pitch (centre-to-centre spacing) of the columnar termination trenches 14 may be the same as that for the columnar trenches 41 of the active transistor cells 40 of the active area 11.

In the active area 11, transistor cells 40 each comprise a columnar trench 41 having a stepped field dielectric structure 19 and the mesas 46 comprise the drift region 20 of a first conductivity type, a body region 21 of a second conductive type that opposes the first conductivity type that is arranged on the drift region 20 and a source region 49 of the first conductive type that is arranged on the body region 21 and that extends to the first surface 11. Typically, the source region 49 is more highly doped than the drift region 20. For example, in some embodiments, the first conductivity type is n-type and the second conductivity type is p-type or vice versa.

In the transition region 50, the inactive cells 13' each comprise a columnar trench 14' having a stepped field dielectric structure 19' and a termination mesa 15' that comprises a body region 21 of the second conductivity type that is arranged on the drift region 20. In the transition region 50, the body region 21 extends to the first surface 22 of the semiconductor substrate 23 so that no source region is provided. These cells 13' are, therefore, inactive. In other embodiments, the field dielectric structure 19' has a different form in which its thickness is greater on the lower portion of the side wall 17 than on the upper portion of the same side wall 17. For example, the field dielectric 19' and the field plate 18' may each have the form illustrated in and described with reference to one of figures 1B 2A and 2B.

In the intermediate termination region 52, the inactive cells 13" comprise a columnar trench 14" having a field dielectric structure 19" having a uniform thickness on the side wall 17 and a termination mesa 15' that comprises a drift region 20 that extends to the first 'surface 22 of the semiconductor substrate 2.3

The transition region 50 is distinguishable from the intermediate termination region 52 by the presence of the body region 20. The region of the semiconductor substrate 23 that is doped with the first conductivity type and provides the source region 49 is laterally smaller than the region of the semiconductor substrate 23 that is doped with the second conductivity type and that forms the body region 21. The lateral extent of the body region 21, as defined by the outer edge of the body region 21, is less than the lateral extent of the drift region 20 and the first surface 22.

The outer termination region 53 that surrounds and, in particular, is contiguous with the intermediate termination region 52 is free of inactive cells. Therefore, the outer termination region 53 is free of columnar trenches and mesas. The outer termination region 53 may include semiconductor material of the first conductivity type.

The mesas 46 of the active cells 40, the termination mesas 15 of the inactive cells 13 of the transition region 50 and of intermediate termination region 52 of the edge termination region 12 include the drift region 20 comprising a first conductivity type. The drift region 20 and the outer termination region 53 may be formed from an epitaxial silicon layer.

If used in the edge termination region 12, the at least one termination trench 30, which may be a continuous trench or comprise a plurality of sections 30' arranged in a ring shape, is positioned in the intermediate termination region 52 and laterally surrounds the array of columnar termination trenches 14'. The termination trench 30 is filled with at least one dielectric material 37. In contrast to the columnar termination trenches 14, the termination trench 30 is free of electrically conductive material and, therefore, free of a field plate. The termination trench 30 has side walls 31, 32 and a base 36 that is positioned at a depth d_{c} from the first major surface 22. The depth d_{c} may be substantially the same as the depth d of the columnar trenches 14, 41 or may be less than or greater than the depth d. The depth d_{c} of the termination trench 30 is, however, greater than the depth d_{g} of the gate trench 60.

The dielectric material 37 positioned in the termination trench 30 has a dielectric constant εr which is lower than the dielectric constant of silicon which has εr of 11.7. Possible dielectric materials for the continuous trench 50 include SiO₂ with εr around 3.9, a vacuum with εr of 1.0 and silicon nitride with εr of around 6.0.

In some embodiments, the lateral shape of the gate trench 60 and the gate electrode 61 in the gate trench 60 has a form corresponding to the form of the columnar trenches 41 such that the distance between the gate trench 60 and the side wall 45 of the individual ones of the columnar trenches 41 is substantially uniform. For example, if the columnar trenches 41 are hexagonal in top view, the gate trench 60 and the gate electrode 61 positioned in the gate trench 60 may have a hexagonal ring shape such that the distance between the inner side wall of the hexagonal ring shape and the side wall 45 of the respective hexagonal columnar trench 41 is substantially uniform between the entire periphery of the columnar trench 41 and the entire inner side wall of the gate trench 60. In other words, the gate trench 60 and gate electrode 61 are arranged concentrically with respect to the columnar trench 41. The individual hexagonal rings of the gate trench 60 may be connected to form a grid shape in top view.

In another example, if the columnar trenches 41 have a square shape in top view, the gate trench 60 and the gate electrode 61 in the gate trench 60 have a square ring shape and the square ring shape is arranged laterally around and concentrically with respect to the columnar trench 41 arranged at its centre such that the distance between the inner side wall of the square ring shape of the gate trench 60 and the side wall 45 of the respective square columnar trench 41 is substantially uniform between the entire periphery of the columnar trench 41 and the entire inner side wall of the gate trench 60.

Figure 6A illustrates a plan view and figure 6B across-sectional view of a portion of the semiconductor device 10, which corresponds to a cross-sectional view of the semiconductor device of figure 5B. Figures 6A and 6B illustrates a portion of the active area 11 and the edge termination region 12 including the transition region 50, the intermediate and outer termination regions 52, 53 arranged in this order concentrically around the active area 11. In this embodiment, the edge termination region 12 further comprises an inner termination region 51 that is arranged between the transition region 50 and the intermediate termination region 52.

In the embodiment illustrated in figures 6A and 6B, the columnar trenches 41 in the active area 11 and the columnar trenches 14 in the edge termination region 12 are arranged in an array having off set rows. The individual trenches 14, 41 are hexagonal in top view and the array has a hexagonal pattern.

In the inner termination region 51, the inactive cells 13 each comprise a columnar trench 14' having a stepped dielectric structure 19' and a termination mesa 15' that comprises a drift region 20 that extends to the first surface 22 of the semiconductor substrate 23. The termination mesa 15' in the inner termination region 51 in contrast to the termination mesas 15' in the transition region 50, does not include a body region.

The inner termination region 51 is also distinguishable from the intermediate termination region 52 in the profile of the field plate dielectric 19. In the intermediate termination region 52, the field dielectric 19" has a uniform thickness on the side wall 17, whereas in the inner termination region 51 the field dielectric 19' has a smaller thickness at the top and a greater thickness in the lower portion of the side wall 17 and may have a stepped profile. The field dielectric 19' may have the same profile in the active area 11, transition region 50 and inner termination region 51.

In some embodiments, such as that shown and described with reference to figures 6A and 6B, the edge termination region 20 further includes a doped region 70 of the second conductivity type. The outermost row of the columnar trenches 14" located in the intermediate termination region 52 is located within the doped region 70. Figure 6B illustrates a cross-sectional view of a portion of the semiconductor substrate 23 with an active area 11 and edge termination region 12 corresponding to that of figure 6A and shows the doped region 70 which laterally surrounds the sidewall 17 and base 16 of the outermost one of the columnar trenches 14" and the termination trench 30. The outermost ones of the array of columnar trenches 14' have a field dielectric having the second field dielectric profile 19' and a substantially uniform thickness over the entire height of the sidewall 17 of the trenches. In other non-illustrated embodiments, the doped region 70 may laterally surround the termination trench 30 and be positioned adjacent to and spaced apart from one or more of the columnar trenches 14", which are positioned in the intermediate termination region 52, by a portion of the drift region 23.

In some embodiments and as illustrated in figures 6A and 6B, the doped region 70 forms a continuous ring of the second conductivity type which laterally surrounds the remainder of the intermediate termination region 52 and extends in the mesa 15" located adjacent at least the outermost row of columnar trenches 14" located in the intermediate termination region 52. In some embodiments, the continuous doped ring 70 of the second conductivity type may be arranged laterally adjacent to the termination trench 30 which laterally surrounds the intermediate termination region 52. The doped region 70 may extend from the first major surface 22 into the substrate 23 by a depth which is at least the depth d of the columnar trenches 14.

Figure 6C illustrates a schematic top view of a semiconductor device 10 with an active area 11 and an edge termination region 12 according to an embodiment. Figure 6D illustrates an enlarged view of figure 6C and Figure 6E a cross-sectional view of the area A-A'. The semiconductor device 10 illustrated in figures 6C to E differs from that illustrated in figures 6A and 6B in that the boundary 54 between the transition region 50, which comprises a body region 21, and the inner termination region 51, which is without a body region, is located intermediate the width of the columnar trenches 14'.

Referring to figures 6C to 6E, a row 1000 of columnar trenches 14, which are denoted with 1001 to 1007, will now be described. In the view of figures 6C and 6D, the row 1000 of columnar trenches 1001 to 1007 are arranged in this order in a vertical direction from the bottom to the top and in the cross-sectional view of figure 6E, the columnar trenches 1001 to 1007 are arranged in this order in the row 1000 from right to left.

The columnar trench 1001 is located in the active area 11 and has a field dielectric 19' having the first non-uniform profile, e.g. the stepped profile of figure 1B or non-uniform profile of figure 2A or 2B. The columnar trench 1001 is laterally surrounded by a mesa 15 comprising a drift region 20, a body region 21 and a source region 49 and also includes a contact 100 electrically connecting the source region 49 and field plate 18' to the overlying source metal 101 that is arranged on the first major surface 22 of the substrate 23.

The adjacent columnar trench 1002 in the row 1000 is located in the transition region 50 of the edge termination region 12 and also comprises a field dielectric 19' having the first non-uniform profile. The columnar trench 1002 is laterally surrounded by a mesa 15 comprising a drift region 20 and a body region 21 that extends to the first major surface 22. The columnar trench 1002 also includes a contact 102 electrically connecting the field plate 18' in the trench 14' to the overlying source metal 101. The columnar trench 1002 differs from the columnar trench 1001 in that the columnar trench 1002 is not surrounded by the source region 49.

The adjacent columnar trench 1003 in the row 1000 is located in the transition region 50 of the edge termination region 12 and also comprises a field dielectric 19' having the first non-uniform profile and is laterally surrounded by a mesa 15 comprising a drift region 20 and a body region 21 that extends to the first major surface 22. The columnar trench 1003 differs from the columnar trench 1002 in that it is devoid of a contact 102 between the body region 21 and the source metal 102.

The adjacent columnar trench 1004 of the row 1000 is located at the boundary 54 between the transition region 50 and the inner termination region 51. The columnar trench 1004 comprises a field dielectric 19' having the first non-uniform profile.

The inboard periphery of the columnar trench 1004 is bounded by a mesa 15' comprising the drift region 20 and body region 21 that extends to the first major surface 22. The outboard facing periphery of the columnar trench 1004 is bounded by a mesa 15' comprising the drift region 20 only. "Inboard" denotes directions facing towards the centre of the first major surface 22 and "outboard" denotes directions facing towards the side faces 56 of the first major surface 22. The columnar trench 1004 is also devoid of a contact between the body region 21 and the source metal 102.

The adjacent columnar trench 1005 of the row 1000 is located in the inner termination region 51 of the edge termination region 12 and comprises a field dielectric 19' having the first non-uniform profile. The columnar trench 1005 is laterally surrounded by a mesa 15 comprising the drift region 20 only that that extends to the first major surface 22.

The transition 55 between the inner termination region 51 and intermediate termination region 52 is also shown in figures 6C to 6E. The next columnar trenches 1006 and 1007 of the row 1000 are located in the intermediate region 52, and are each laterally entirely surrounded by a mesa 15" formed of the drift region 20 only. The columnar trenches 1007 and 1008 each have a field plate 18" having a substantially uniform cross-sectional area over its height and a field dielectric 19" having a substantially uniform thickness over the entire height of the side wall 17 of the trench 14". Figures 6C and 6D also illustrate the gate 104 located in the mesas 15. The field plates 18', 18" in all of the columnar trenches are electrically connected to source potential.

The termination trench 30 is located outboard of the columnar trench 1008 and in the embodiment illustrated in figure 6C is a continuous trench. The termination trench 30 has an inner side wall 31 and an outer side wall 32 that are substantially parallel to one another such that the trench has a substantially uniform width. The termination trench 30 laterally surrounds the columnar trenches 14" and has a meandering form in top view such that the spacing between the inner side wall 31 and the outermost row or ring of columnar trenches 14" is substantially the same. In other words, the outermost mesa 15" has a substantially uniform width. The continuous termination trench 30 may however be replaced by a termination trench comprising a plurality of separate trench sections arranged in a ring.

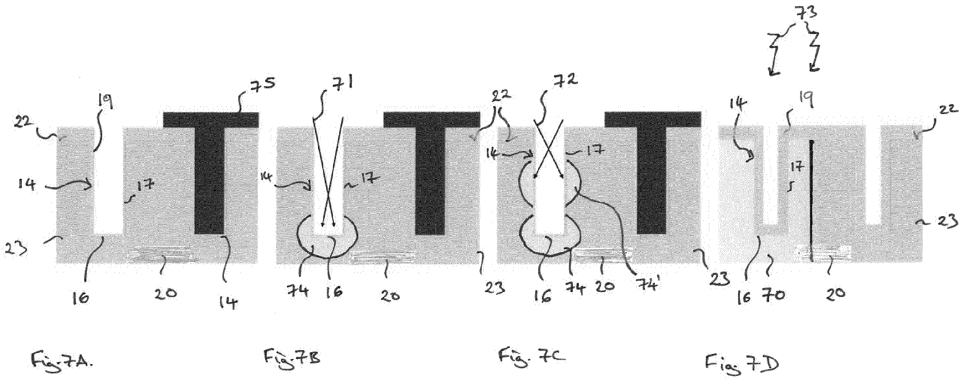

Figures 7A to 7D illustrates a method with which the doped region 70 may be fabricated in a semiconductor device, such as a transistor device. Referring to figure 7A, a plurality of columnar trenches 14 are formed in a first major surface 22 of a semiconductor substrate 23 having a first conductivity type, the columnar trenches 14 each having a base 16 and a side wall 17 extending form the base 16 to the first major surface 22. The columnar trenches 14 may be arranged in an array of offset rows or in a square grid array. The plurality of trenches 14 are arranged in the edge termination region 12 of the semiconductor device 10 and may also be arranged in the active area 11 of the semiconductor device 10. The columnar trenches 14 may be formed by etching, for example. The base 16 and side wall 17 of the columnar trenches 14 are lined with a field dielectric 19 which also extends over the first major surface 22 of the semiconductor substrate 23.

A dielectric layer 90 may be formed on the first major surface 22 and optionally on the side wall 17 and base 16 of the trenches 14. The dielectric layer 90 is thicker on the first major surface 22 than on the side wall 17 and base 16 of the trenches 14. The dielectric layer 90 may be formed by thermal growth of an oxide, e.g. oxidation of the silicon substrate to form a silicon oxide lining and/or deposition of a dielectric, e.g. TEOS deposition of SiOx.

Referring to figure 7B, at least some of the columnar trenches 14 are covered, for example by a mask 75, so that the dopants of the second conductivity type are not implanted to the covered columnar trenches 14. The covered columnar trenches 14 may be located in the active area 11 and also in laterally inboard parts of the edge termination region 12. Dopants of the second conductivity type are implanted into the base and adjoining portions of the side walls of an outermost one of the columnar trenches 14" that remain uncovered by the mask 75. The dopants are implanted over a first depth range of the columnar 14 from the first major surface 22, as shown schematically by the arrows 71, to form a doped region 74 that laterally surrounds the base 16 and lower side wall 17 of the trench 14.

In some embodiments and referring to figure 7C, the dopants of the second conductivity type are implanted into the side walls 17 of the outermost one of the columnar trenches 14 over a second depth range from the first major surface 22, as shown schematically by the arrows 72, to form a further doped region 74' arranged vertically above the doped region 74. At least a part of the second depth range is vertically adjacent the first depth range. The depth range of the implant may be selected by selecting the angle or tilt of the implant. A wider tilt is used for a lower depth from the first major surface 22.

Referring to figure 7D, after implantation of the dopants of the second conductivity type at one, two or more depths, to form one, two or more doped regions 74, 74', a so-called drive-in process may be carried out, e.g. by thermal annealing, as is schematically indicated by the arrows 73. This may be carried out after removing the mask 75. The annealing process may be used to form a continuous doped column and/or lateral doped ring 70 from the doped region(s) 74, 74'.

In some embodiments, the dielectric layer 90 is removed and the field dielectric 19 is formed on the side wall 17 and base 16 of the columnar trenches 14. The field dielectric 19 may be formed by thermal growth of an oxide, e.g. oxidation of the silicon substrate to form a silicon oxide lining and/or deposition of a dielectric, e.g. TEOS deposition of SiOₓ, before the thermal annealing process or drive-in process is carried out. Afterwards, conductive material 18 for the field plates is inserted into the columnar trenches 14.

In some embodiments, a continuous ring 70 of the second conductivity type is formed that extends from the first major surface 22 of the semiconductor substrate 23 into the semiconductor substrate 23. In some embodiments, one or more of the outermost rows or rings of columnar trenches 14 in the edge termination region 12 are located in and surrounded by the continuous doped ring 70 of the second conductivity type-This arrangement may result from the spreading of the implanted regions 74 as a result of the thermal annealing process. The doped ring 70 may extend into the semiconductor substrate 23 by a depth that is at least as greater or greater than the depth d of the base 16 of the columnar trenches 14 from the first major surface 22 of the semiconductor substrate 23.

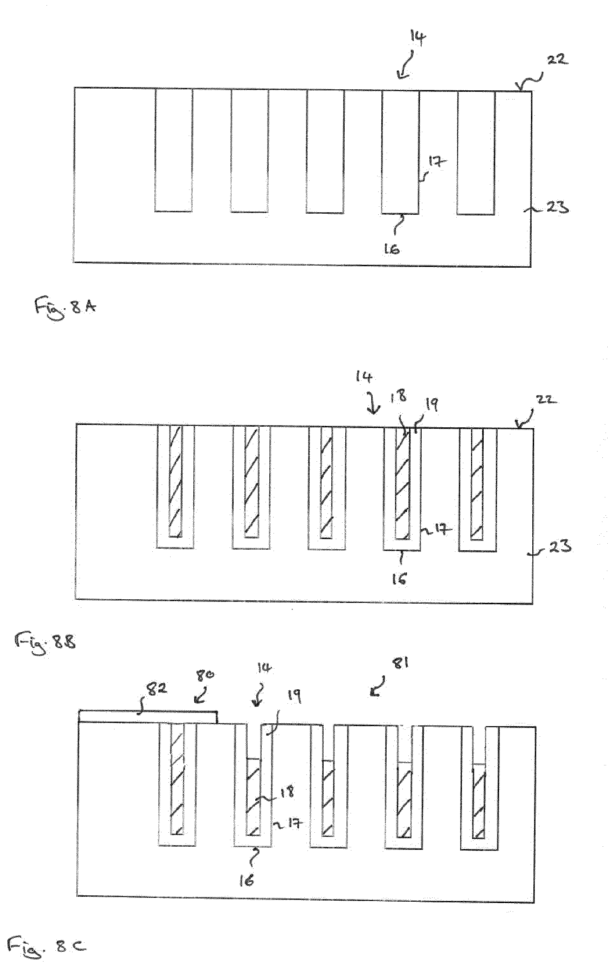

Figures 8A to 8H illustrates a method with which the columnar trench 14 with a field dielectric 19 having a stepped profile 19' can be fabricated. Referring to figure 8A, at least one columnar trench 14 is formed in a first major surface 22 of a semiconductor substrate 23 having a first conductivity type. Typically, a plurality of columnar trenches 14 are formed that are arranged in an array, e.g. a square grid array or offset rows, having a common spacing. Each columnar trench 14 has a base 16 and a side wall 17 extending form the base 16 to the first major surface 22. The plurality of trenches 14 may be arranged in the edge termination region 12 and/or in the active area 11 of the semiconductor device 10. The columnar trenches 14 may be formed by etching, for example.

Referring to figure 8B, the base 16 and side wall 17 of the columnar trenches 14 are then lined with a field dielectric 19. The field dielectric 19 may be formed by thermal growth of an oxide, e.g. oxidation of the silicon substrate 23 to form a silicon oxide lining and/or deposition of a dielectric, e.g. TEOS deposition of SiOx. Conductive material 18 is then inserted into the columnar trenches 14 which may be used to form a field plate.

Referring to figure 8C, a second subset 80 of the plurality of columnar trenches 14 that lies laterally outboard of a first subset 81 of the plurality of columnar trenches 14 is covered by a cover, e.g. a mask 82, leaving the first subset 81 uncovered. Whilst covering the second subset 80 of the plurality of columnar trenches 14 that lies laterally outboard of a first subset 81 of the plurality of columnar trenches14, the following method is carried out in the first subset of trenches 80. An upper portion of the conductive material 18 is removed from an upper portion of the columnar trenches 14 and the field dielectric 19 arranged on the side wall 17 is exposed.

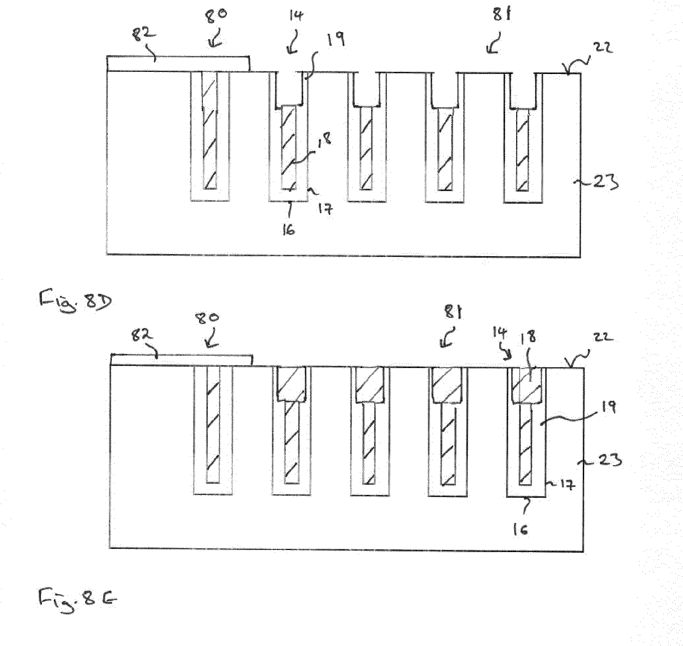

Referring to figure 8D, a portion of the exposed field dielectric 19 is removed and the thickness of the exposed field dielectric 19 arranged on the side wall of the upper portion of the columnar trenches 14 is reduced. The side wall 17 in the upper portion of the trench 14 remains covered by a thin layer of the field dielectric 19.

Referring to figure 8E, conductive material 18 is inserted into the columnar trench 14 and the upper portion of the trench 14 is filled with the conductive material 18 to from a field plate 18 with a wider upper portion and narrower lower portion. Consequently, the field dielectric 19 has a smaller thickness in the upper portion and a larger thickness in the lower portion of the columnar trench 14 has a stepped profile.

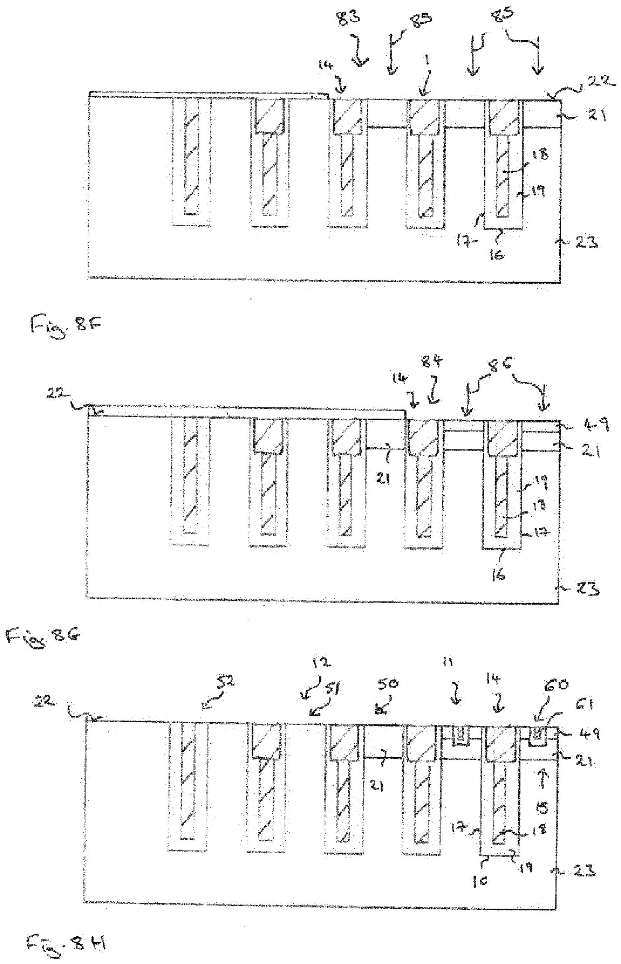

The method may continue by forming the transistor device and further features of the edge termination region 12 and active region 11. Referring to Figure 8F, dopants of a second conductivity type are implanted into a first predetermined area 83 of the first major surface to form a body region 20 as is indicated schematically by the arrows 85. The second subset 81 of the plurality of columnar trenches 14 is positioned laterally outboard of the first predetermined area 83. In some embodiments, the entire first subset 80 of the plurality of columnar trenches 14 is positioned laterally within the first predetermined area 83. In other embodiments, one or more or the outermost ones of the columnar trenches of the first subset 80 is positioned laterally outside of the first predetermined area 83.

Referring to figure 8G, dopants of the first conductive type are implanted into a second predetermined area 84 that is smaller than the first predetermined area 83, as is indicated schematically with the arrows 86. The dopants of the first conductive type form the source region 49 so that the second predetermined area 84 corresponds to the active area 11 of the transistor device.

A gate trench 60 and gate electrode 61 may be them be formed in the mesas 15 between neighbouring ones of the columnar trenches 14 in the second predetermined area 84, as shown in figure 8H.

The performance of transistor devices, including MOSFET devices is improved due to the structure of the edge termination region according to any one of the embodiments described herein and an improved avalanche robustness and a low on-state resistance is achieved.

Although the present disclosure is not so limited, the following numbered examples demonstrate one or more aspects of the disclosure.

### Examples

Example 1. A semiconductor device, comprising:
an active area and an edge termination region laterally surrounding the active area, wherein
the active area comprises a plurality of active transistor cells,
the edge termination region comprises a plurality of inactive cells, each inactive cell comprising a columnar trench and a termination mesa arranged adjacent to the columnar trench;
wherein each of the columnar trenches comprises a base, a side wall, a field plate, and a field dielectric arranged on the base and the side wall and surrounding the field plate, wherein each of the field dielectrics has a first thickness in an upper region of the field plate and a second thickness in a lower region of the field plate, the first thickness being smaller than the second thickness, and
wherein each of the termination mesas comprises a drift region of a first conductivity type and a body region of a second conductivity type arranged above the drift region.

Example 2. The semiconductor device of example 1, wherein the plurality of inactive transistor cells are directly adjacent to one or more of the plurality of active transistor cells.

Example 3. A semiconductor device according to example 1 or example 2, wherein the upper region is contiguous to the body region and the lower region is contiguous to the drift region, wherein the first thickness (t₁) is equal to or smaller than 1.15 times the second thickness (t₂) or t₁ ≤ 1.2 t₂ or t1 ≤ 1.5 t₂.

Example 4. A semiconductor device according to any one of examples 1 to 3, wherein the side face of each of the field plates comprises a step such that an upper portion of the field plate has a width that is greater than a width of a lower portion of the field plate and such that the field dielectric has the first thickness t₁ in the upper region and the second thickness t2 in the lower region.

Example 5. A semiconductor device according to example 4, wherein the step is located at a first depth (d₁) from the first major surface of the semiconductor substrate and a pn junction is formed between the body region and the drift region at a second depth (dₚₙ) from the first major surface of the semiconductor substrate, wherein the first depth (d₁) is greater than the second depth (dₚₙ).

Example 6. A semiconductor device according to any one of examples 1 to 5, wherein the field plate of the first columnar trenches has a T-shape and the field plate of the second columnar trenches has a columnar shape.

Example 7. A semiconductor device according to any one of examples 1 to 6, wherein the one or more inactive transistor cells are comprised in a transition region of the edge termination region that laterally surrounds the active region, wherein the edge termination region further comprises an inner termination region that laterally surrounds the transition region, wherein the inner termination region comprises a second plurality of inactive cells, each inactive cell of the second plurality of inactive cells comprising a second columnar trench having a base and a side wall and comprising a field plate and a second termination mesa comprising a drift region of a first conductivity type and no body region of the second conductivity type, wherein the drift region extends to the first major surface; wherein each field dielectric of the second columnar trenches has the first thickness adjacent an upper region of the field plate and the second thickness adjacent a lower region of the field plate.

Example 8. A semiconductor device according to example 7, wherein the edge termination region further comprises an intermediate termination region that laterally surrounds the inner termination region, wherein the intermediate termination region comprises one or more inactive cells, each inactive cell comprising a third columnar trench having a base and a side wall and comprising a field plate and a third termination mesa comprising a drift region of a first conductivity type and no body region of the second conductivity type, wherein the drift region extends to the first major surface; wherein the third columnar trench comprises a field dielectric that is arranged on the base and the side wall and that has a thickness, t₂, on the side wall that varies by less than ± 1.1 t₂.

Example 9. A semiconductor device according to any one of examples 1 to 8, wherein the first and second and third columnar trenches are arranged in an array comprising offset rows, wherein the array is in the transition region and the intermediate termination region, and the pitch of the first and second columnar and third trenches in the array is substantially equal throughout the array.

Example 10. A semiconductor device according example 9, wherein the array is further arranged in the active area.

Example 11. A semiconductor device according to any one of examples 1 to 10, wherein in the transition region the body region of the termination mesa extends to the first major surface.

Example 12. A semiconductor device according to one of examples 1 to117, wherein the edge termination region further comprises a continuous ring of the second conductivity type that laterally surrounds the plurality of inactive cells.

Example 13. A semiconductor device according to example 12, wherein the continuous ring of the second conductivity type is arranged laterally adjacent to a continuous trench that laterally surrounds the continuous ring and that comprises a field plate.

Example 14. A semiconductor device according to any one of examples 1 to 13, wherein the edge termination region further comprises an outer termination region that laterally surrounds the intermediate termination region and extends to the side face of the semiconductor substrate, wherein the outer termination region is devoid of columnar trenches.

Example 15. A semiconductor device according to any one of examples 1 to 14, wherein the edge termination region further comprises at least one termination trench that laterally surrounds the intermediate transition region and that comprises dielectric material.

Example 16. A semiconductor device according to example 15, wherein the termination trench is continuous and uninterrupted laterally surrounds the intermediate transition region or the termination trench comprises a plurality of trench sections arranged in a ring that laterally surrounds the intermediate transition region.

Example 17. A semiconductor device according to example 15 or example 16, wherein the termination trench laterally surrounds the continuous ring of the second conductivity type.

Example 18. A semiconductor device according to any one of examples 15 to 17, wherein the termination trench is spaced apart from an outermost columnar termination trench by a distance dₒᵤₜₑᵣ and 50 nm ≤ dₒᵤₜₑᵣ ≤ 2 µm.

Example 19. A semiconductor device according to any one of examples 15 to 18, wherein the dielectric material comprises portions of differing composition.

Example 20. A semiconductor device according to any one of examples 15 to 19, wherein the dielectric material comprises at least one dielectric layer that lines sidewalls and a base of the continuous trench.

Example 21. A semiconductor device according to any one of examples 15 to 20, wherein the at least one dielectric layer surrounds a gap or an enclosed cavity positioned in the continuous trench.

Example 22. A semiconductor device according to any one of examples 15 to 21, wherein the dielectric material comprises a first dielectric layer and a second dielectric layer arranged on the first dielectric layer.

Example 23. A semiconductor device according example 22, wherein the first dielectric layer is thinner than the second dielectric layer.

Example 24. A semiconductor device according to example 22 or example 23, wherein the first dielectric layer is a thermally grown SiOₓ layer and the second dielectric layer is a TEOS layer.

Example 25. A semiconductor device according to one of examples 1 to 24, wherein each active transistor cell comprises a mesa and a columnar trench, and the mesa comprises the drift region, the body region arranged on the drift region, a source region of the first conductivity type arranged on the body region and a gate trench comprising a gate electrode.

Example 26. A semiconductor device according to example 25, wherein the columnar trench of each active transistor cell comprises a base, a side wall, a field plate, and a field dielectric arranged on the base and the side wall and surrounding the field plate, wherein the field dielectric has a first thickness in an upper region of the field plate and a second thickness in a lower region of the field plate, the first thickness being smaller than the second thickness.

Example 27. A semiconductor device according to example 25 or example 26, wherein the gate trench extends through the source region and the body region into the drift region, wherein each of the columnar trenches extends from the first surface through the body region and into the drift region.

Example 28. A semiconductor device according to any one of examples 25 to 27, further comprising at least one gate finger extending from the active area over the edge termination region to a gate runner.

Example 29. A semiconductor device according to example 28, wherein the gate runner is positioned laterally between the side face of the semiconductor body and the continuous trench in the outer termination region.

Example 30. A method for fabricating a semiconductor device, the method comprising:
forming a plurality of columnar trenches in a first major surface of a semiconductor substrate having a first conductivity type, the columnar trenches being arranged in an array of offset rows and each having a base and a side wall extending form the base to the first major surface;
lining the base and side wall of the columnar trenches with a field dielectric;
inserting conductive material into the columnar trenches;
whilst covering a second subset of the plurality of columnar trenches that lies laterally outboard of a first subset of the plurality of columnar trenches, in the first subset of trenches:
   removing an upper portion of the conductive member from an upper portion of the columnar trenches and exposing the field dielectric arranged on the side wall;
   removing a portion of the exposed field dielectric and reducing the thickness of the exposed field dielectric arranged on the side wall of the upper portion of the columnar trenches;
   inserting conductive material into the columnar trench and filling the upper portion of the trench with the conductive material;
implanting dopants of a second conductivity type into a first predetermined area of the first major surface to form a body region, wherein the second subset of the plurality of columnar trenches is positioned laterally outboard of the first predetermined area and the first subset of the plurality of columnar trenches is positioned laterally within the first predetermined area;
implanting dopants of the first conductive type into a second predetermined area that is smaller than the first predetermined area.

Example 31. A method according to example 30, wherein an outer one of the first subset of the plurality of columnar trenches is positioned laterally outboard of the first predetermined area and in the second predetermined area.

Example 32. A method according to example 30 or example 31, wherein an outermost one of the first subset of the plurality of columnar trenches is arranged laterally outboard of the second predetermined area.

Example 33. A method according to any one of examples 30 to 32, further comprising:
forming a termination trench that laterally surrounds the array of columnar trenches, the termination trench having a base and side walls;
implanting dopants of the second conductivity type into the side walls of the termination trench over a first depth range from the first major surface.

Example 34. A method according to example 33, wherein the termination trench is continuous and uninterrupted laterally surrounds the array of columnar trenches or the termination trench comprises a plurality of trench sections arranged in a ring and the ring laterally surrounds the array of columnar trenches.

Example 35. A method according to example 33 or example 34, further comprising implanting dopants of the second conductivity type into the base of the termination trench.

Example 36. A method according to any one of examples 33 to 35, further comprising: implanting dopants of the second conductivity type into the side walls of the termination trench over a second depth range from the first major surface, wherein at least a part of the second depth range is vertically adjacent the first depth range.

Example 37. A semiconductor device, comprising:
an active area and an edge termination region laterally surrounding the active area, wherein
the active area comprises a plurality of active transistor cells,
the edge termination region comprises a termination trench, a first inactive cell and a second inactive cell, wherein the first inactive cell comprises a first columnar trench and the second inactive cell comprises a second columnar trench,
wherein the first inactive cell and the second inactive cell are arranged directly adjacent to each other and directly adjacent to the termination trench,
wherein the termination trench is filled completely with a dielectric, and
wherein the first trench and the second are arranged in an array comprising offset rows, and
wherein a shortest distance between the termination trench and the first columnar trench and a shortest distance between the termination trench and the second columnar trench is the same.

Example 38. A semiconductor device according to example 37, wherein the shortest distance between the termination trench and the first columnar trench is smaller than a shortest distance between the first columnar trench and the second columnar trench.

Example 39. A semiconductor device according to example 37 or example 38, wherein the termination trench comprises an inner and an outer side wall section, wherein the inner and outer sidewall sections extend substantially parallel to one another.

Example 40. A semiconductor device according to example 39, wherein the termination trench is a continuous trench that laterally surrounds the active area and comprises a meandering form in top view such that the spacing of the inner side wall section from the first columnar trench and from the second columnar trench is substantially uniform and such that the spacing of the outer side wall section from the first columnar trench and from the second columnar trench is substantially uniform, or the termination trench comprises a plurality of trench sections arranged in a ring, wherein the ring laterally surrounds the active area and comprises a meandering form in top view such that the spacing of the inner side wall section from the first columnar trench and from the second columnar trench is substantially uniform and such that the spacing of the outer side wall section from the first columnar trench and from the second columnar trench is substantially uniform.

Example 41. A semiconductor device according to any one of examples 37 to 40, wherein the first and second columnar trenches have a plurality of side wall sections, adjoining side wall sections forming an internal angle α₁ of greater than 90° and wherein a shortest distance between the termination trench and at least two adjoining side walls sections of the first columnar trench and a shortest distance between the termination trench and at least two adjoining side wall sections of the second columnar trench is substantially the same.

Example 42. A semiconductor device according to example 41, wherein the inner and outer side wall section each comprise a plurality of side wall subsections, wherein adjoining side wall subsections forming an internal angle α₂ and α_{2 =} α₁.

Example 43. A semiconductor device according to any one of examples 37 to 42, wherein the first and second inactive cells are arranged in an intermediate termination region of the edge termination region, wherein the first inactive cell further comprises a field plate arranged in the first columnar trench and a termination mesa comprising a drift region of a first conductivity type, wherein the drift region extends to the first major surface and the second inactive cell further comprises a field plate arranged in the second columnar trench and a termination mesa comprising a drift region of a first conductivity type, wherein the drift region extends to the first major surface.

Example 44. A semiconductor device according to example 43,
wherein the edge termination region further comprises a transition region that laterally surrounds the active area, and the intermediate termination region laterally surrounds the transition region,
wherein the transition region comprises at least one third inactive cell, the third inactive cell comprising a third columnar trench comprising a field plate and a termination mesa comprising a drift region of a first conductivity type and a body region of the second conductivity type that opposes the first conductivity type, wherein the body region is arranged on the drift region.

Example 45. A semiconductor device according to any one of examples 37 to 44, wherein the body region extends to the first major surface of the semiconductor substrate.

Example 46. A semiconductor device according to example 45, wherein the first, second and third columnar trenches are arranged in the array and the array is arranged in the active area, in the transition region and the intermediate termination region, wherein the pitch of the first, second and third columnar trenches in the array is substantially equal throughout the array.

Example 47. A semiconductor device according to any one of examples 37 to 46, wherein the third columnar trenches each comprise a base, a side wall and a field dielectric that is arranged on the base and the side wall, wherein the field dielectric has a thickness t₁ in a first region of the side wall that is contiguous to the body region and a thickness t₂ in a second region of the side wall that is contiguous to the drift region, wherein t₁ ≤ 1.15 t₂) or t₁ ≤ 1.2 t₂ or t1 ≤ 1.5 t₂,

Example 48. A semiconductor device according to example 47, wherein the side face of the field plate of the third columnar trenches comprises a step such that an upper portion of the field plate has a width that is greater than a width of a lower portion of the field plate and such that the field dielectric has the thickness t₁ in the first region of the third columnar trench and the thickness t2 in the second region of the third columnar trench.

Example 49. A semiconductor device according to example 48, wherein the step is located at a depth d₁ from the first major surface of the semiconductor substrate and the pn junction formed between the body region and the drift region has a depth dₚₙ from the first major surface of the semiconductor substrate, wherein d₁ > dₚₙ.

Example 50. A semiconductor device according to any one of examples 37 to 49, wherein the field plate of the third columnar trenches has a T-shape and the field plate of the second columnar trenches has a columnar shape.

Example 51. A semiconductor device according to any one of examples 37 to 50, wherein the first and second columnar trenches each comprise a base, a side wall and a field dielectric that is arranged on the base and the side wall, wherein the field dielectric that has a thickness, t₂, on the side wall that varies by less than ± 1.1 t₂.

Example 52. A semiconductor device according to one of examples 37 to 51, wherein the edge termination region further comprises an inner termination region that laterally surrounds the transition region, wherein the intermediate termination region laterally surrounds the inner termination region and the inner termination region comprises one or more third inactive cells comprising a third columnar trench comprising a field plate and a termination mesa comprising a drift region of the first conductivity type that extends to the first surface.

Example 53. A semiconductor device according to one of examples 37 to 54, wherein each active transistor cells comprises a mesa and a third columnar trench, wherein the mesa comprises the drift region of the first conductivity type, the body region arranged on the drift region, a source region of the first conductivity type arranged on the body region and a gate trench comprising a gate electrode.

Example 54. A semiconductor device according to any one of examples 37 to 53, wherein the edge termination region further comprises an outer termination region that laterally surrounds the intermediate termination region and extends to the side face of the semiconductor substrate, wherein the outer termination region is devoid of columnar trenches.

Example 55. A semiconductor device according to any one of examples 37 to 54, wherein the edge termination region further comprises at least one termination trench that laterally surrounds the intermediate transition region and that comprises dielectric material.

Example 56. A semiconductor device according to example 55, wherein the termination trench is continuous and uninterrupted laterally surrounds the intermediate transition region or the termination trench comprises a plurality of trench sections arranged in a ring that laterally surrounds the intermediate transition region.

Example 57. A semiconductor device according to example 55 or example 56, wherein the termination trench laterally surrounds the continuous ring of the second conductivity type.

Example 58. A semiconductor device according to any one of examples 37 to 57, wherein the termination trench is spaced apart from an outermost columnar termination trench by a distance dₒᵤₜₑᵣ and 50 nm ≤ dₒᵤₜₑᵣ ≤ 2 µm.

Example 59. A semiconductor device according to any one of examples 37 to 58, wherein the dielectric material comprises portions of differing composition.

Example 60. A semiconductor device according to any one of examples 37 to 59, wherein the dielectric material comprises at least one dielectric layer that lines sidewalls and a base of the continuous trench.

Example 61. A semiconductor device according to any one of examples 37 to 60, wherein the at least one dielectric layer surrounds a gap or an enclosed cavity positioned in the continuous trench.

Example 62. A semiconductor device according to any one of examples 37 to 61, wherein the dielectric material comprises a first dielectric layer and a second dielectric layer arranged on the first dielectric layer.

Example 63. A semiconductor device according example 62, wherein the first dielectric layer is thinner than the second dielectric layer.

Example 64. A semiconductor device according to example 62 or example 63, wherein the first dielectric layer is a thermally grown SiOₓ layer and the second dielectric layer is a TEOS layer.

Example 65. A semiconductor device, comprising:
an active area and an edge termination region laterally surrounding the active area, wherein
the active area comprises a plurality of active transistor cells,
the edge termination region comprises one or more first inactive cells and one or more second inactive cells,
wherein each of the one or more first inactive transistor cells comprises a first columnar trench having a first base and a first side wall and comprises a first field plate and a first field dielectric structure that is arranged on the first base and the first side wall and that surrounds the first field plate,
wherein each of the one or more second inactive transistor cells comprises a second columnar trench having a second base and a second side wall and comprises a second field plate and a second field dielectric structure that is arranged on the second base and the second side wall and that surrounds the second field plate,
wherein the first field dielectric structure has a different thickness profile than the second field dielectric structure.

Example 66. A semiconductor device according to example 65, wherein the semiconductor device comprises a semiconductor substrate in which the active area and the edge termination region are formed, wherein the substrate has an edge surrounding a first major surface and the second inactive cells are closer to an edge of the semiconductor substrate than the first inactive transistor cells.

Example 67. A semiconductor device according to example 65 or example 66, wherein the field dielectric of the first columnar trench has a thickness that is greater on a lower portion of the side wall than on an upper portion of the side wall and the field dielectric of the second columnar trench has a thickness that is substantially uniform.

Example 68. A semiconductor device according to any one of examples 65 to 68, wherein the field dielectric of the first columnar trench has a thickness t₁ in an upper region of the side wall and a thickness t₂ in a lower region of the side wall, wherein t₁ ≤ 1.15 t₂ or t₁ ≤ 1.2 t₂ or t1 ≤ 1.5 t₂.

Example 69. A semiconductor device according to any one of examples 65 to 68, wherein the side face of the field plate of the first columnar trenches comprises a step such that an upper portion of the field plate has a width that is greater than a width of a lower portion of the field plate and such that the field dielectric has the thickness t₁ in the first region of the first columnar trench and the thickness t2 in the second region of the first columnar trench.

Example 70. A semiconductor device according to example 69, wherein the first inactive cells further comprise a termination mesa, wherein the termination mesa comprises a drift region of a first conductivity type and a body region of a second conductivity type that opposes the first conductivity type and the body region is arranged on the drift region, wherein the step is located at a depth d₁ from the first major surface of the semiconductor substrate and the pn junction formed between the body region and the drift region has a depth dₚₙ from the first major surface of the semiconductor substrate, wherein d₁ > dₚₙ.

Example 71. A semiconductor device according to any one of examples 65 to 70, wherein the second inactive cells each comprises a field dielectric that is arranged on the base and the side wall and that has a thickness, t₂, on the side wall that varies by less than ± 1.1 t₂.

Example 72. A semiconductor device according to any one of examples 65 to 71, wherein the field plate of the first columnar trenches has a T-shape and the field plate of the second columnar trenches has a columnar shape.

Example 73. A semiconductor device according to any one of examples 65 to 72, wherein the edge termination region comprises a transition region that laterally surrounds the active region and one or more of the first inactive cells are arranged in the transition region.

Example 74. A semiconductor device according to example 73, wherein the edge termination region further comprises an intermediate region that laterally surrounds the transition region and the one or more second inactive cells are arranged in the intermediate region.

Example 75. A semiconductor device according to example 73 or example 74, wherein the edge termination region further comprises an inner termination region that laterally surrounds the transition region, wherein the intermediate termination region laterally surrounds the inner termination region, wherein one or more of the first inactive cells are arranged in the inner termination region comprises one or more inactive cells comprising a first columnar trench comprising a field plate and a termination mesa comprising a drift region of the first conductivity type that extends to the first surface.

Example 76. A semiconductor device according to any one of examples 74 to 75, wherein in the transition region, the first inactive cells comprise a mesa comprising a drift region and a body region is arranged on the drift region, wherein the body region extends to the first major surface, in the inner termination region, , the first inactive cells comprise a mesa comprising a drift region extending to the first major surface and in the intermediate region the second inactive cells comprise a mesa comprising a drift region and the drift region extends to the first major surface.

Example 77. A semiconductor device according to one of examples 74 to 76, wherein the first and second columnar trenches are arranged in an array comprising offset rows, wherein the array is arranged in the active area, in the transition region, the inner termination region and the intermediate termination region, and the pitch of the first and second columnar trenches in the array is substantially equal throughout the array.

Example 78. A semiconductor device according to one of examples 65 to 77, wherein the active transistor cells each comprise a first columnar trench and an active mesa, wherein each active mesa comprises the drift region of the first conductivity type, the body region arranged on the drift region, a source region of the first conductivity type arranged on the body region and a gate trench comprising a gate electrode.

Example 79. A semiconductor device according to one of examples 65 to 78, wherein the edge termination region further comprises a continuous ring of the second conductivity type that is arranged laterally outboard of the outermost second columnar trench in the intermediate termination region.

Example 80. A semiconductor device according to example 79, wherein the continuous ring of the second conductivity type is arranged laterally adjacent to a continuous trench that laterally surrounds the intermediate termination region and that comprises a field plate.

Example 81. A semiconductor device according to any one of examples 65 to 80, wherein the edge termination region further comprises an outer termination region that laterally surrounds the intermediate termination region and extends to the side face of the semiconductor substrate, wherein the outer termination region is devoid of columnar trenches.

Example 82. A semiconductor device according to any one of examples 65 to 81, wherein the edge termination region further comprises at least one termination trench that laterally surrounds the intermediate transition region and that comprises dielectric material.

Example 83. A semiconductor device according to example 82, wherein the termination trench is continuous and uninterrupted laterally surrounds the intermediate transition region or the termination trench comprises a plurality of trench sections arranged in a ring that laterally surrounds the intermediate transition region.

Example 84. A semiconductor device according to example 82 or example 83, wherein the termination trench laterally surrounds the continuous ring of the second conductivity type.

Example 85. A semiconductor device according to any one of examples 82 to 84, wherein the termination trench is spaced apart from an outermost columnar termination trench by a distance dₒᵤₜₑᵣ and 50 nm ≤ dₒᵤₜₑᵣ ≤ 2 µm.

Example 86. A semiconductor device according to any one of examples 82 to 85, wherein the dielectric material comprises portions of differing composition.

Example 87. A semiconductor device according to any one of examples 82 to 86, wherein the dielectric material comprises at least one dielectric layer that lines sidewalls and a base of the continuous trench.

Example 88. A semiconductor device according to any one of examples 82 to 87, wherein the at least one dielectric layer surrounds a gap or an enclosed cavity positioned in the continuous trench.

Example 89. A semiconductor device according to any one of examples 82 to 88, wherein the dielectric material comprises a first dielectric layer and a second dielectric layer arranged on the first dielectric layer.

Example 90. A semiconductor device according example 89, wherein the first dielectric layer is thinner than the second dielectric layer.

Example 91. A semiconductor device according to example 89 or example 90, wherein the first dielectric layer is a thermally grown SiOₓ layer and the second dielectric layer is a TEOS layer.

Example 92. A semiconductor device according to any one of examples 78 to 91, wherein the gate trench extends through the source region and the body region into the drift region, wherein each of the columnar trenches extends from the first surface through the body region and into the drift region.

Example 93. A semiconductor device according to any one of examples 78 to 92, further comprising at least one gate finger extending from the active area over the edge termination region to a gate runner.

Example 94. A semiconductor device according to example 93, wherein the gate runner is positioned laterally between the side face of the semiconductor body and the continuous trench in the outer termination region.

Spatially relative terms such as "under", "below", "lower", "over", "upper" and the like are used for ease of description to explain the positioning of one element relative to a second element. These terms are intended to encompass different orientations of the device in addition to different orientations than those depicted in the figures. Further, terms such as "first", "second", and the like, are also used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise. It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A semiconductor device, comprising:
an active area and an edge termination region laterally surrounding the active area, wherein
the active area comprises a plurality of active transistor cells,
the edge termination region comprises a first plurality of inactive cells, each of the first plurality of inactive cells comprising a columnar trench and a termination mesa arranged adjacent to the columnar trench;
wherein each of the columnar trenches comprises a base, a side wall, a field plate, and a field dielectric arranged on the base and the side wall and surrounding the field plate, wherein each of the field dielectrics has a first thickness in an upper region of the field plate and a second thickness in a lower region of the field plate, the first thickness being smaller than the second thickness, and
wherein each of the termination mesas comprises a drift region of a first conductivity type and a body region of a second conductivity type arranged above the drift region.

2. The semiconductor device of claim 1, wherein the first plurality of inactive transistor cells are directly adjacent to one or more of the plurality of active transistor cells.

3. A semiconductor device according to claim 1 or claim 2, wherein the upper region is contiguous to the body region and the lower region is contiguous to the drift region, wherein the first thickness (t₁) is equal to or smaller than 1.15 times the second thickness (t₂) or t₁ ≤ 1.2 t₂ or t1 ≤ 1.5 t₂.

4. A semiconductor device according to any one of claims 1 to 3, wherein the side face of each of the field plates comprises a step such that an upper portion of the field plate has a width that is greater than a width of a lower portion of the field plate and such that the field dielectric has the first thickness t₁ in the upper region and the second thickness t2 in the lower region.

5. A semiconductor device according to any one of claim 4, wherein the step is located at a first depth (d₁) from the first major surface of the semiconductor substrate and a pn junction is formed between the body region and the drift region at a second depth (dₚₙ) from the first major surface of the semiconductor substrate, wherein the first depth (d₁) is greater than the second depth (dₚₙ).

6. A semiconductor device according to any one of claims1 to 5, wherein the first plurality of inactive transistor cells are comprised in a transition region of the edge termination region that laterally surrounds the active region,
wherein the edge termination region further comprises an inner termination region that laterally surrounds the transition region, wherein the inner termination region comprises a second plurality of inactive cells, each inactive cell of the second plurality of inactive cells comprising a second columnar trench having a base and a side wall and comprising a field plate and a second termination mesa comprising a drift region of a first conductivity type and no body region of the second conductivity type, wherein the drift region extends to the first major surface; wherein each field dielectric of the second columnar trenches has the first thickness adjacent an upper region of the field plate and the second thickness adjacent a lower region of the field plate.

7. A semiconductor device according to any one of claim 6, wherein the edge termination region further comprises an intermediate termination region that laterally surrounds the inner termination region, wherein the intermediate termination region comprises a third plurality of inactive cells, each of the third plurality of inactive cell comprising a third columnar trench having a base and a side wall and comprising a field plate and a third termination mesa comprising a drift region of a first conductivity type and no body region of the second conductivity type, wherein the drift region extends to the first major surface;
wherein the third columnar trench comprises a field dielectric that is arranged on the base and the side wall and that has a thickness, t₂, on the side wall that varies by less than ± 1.1 t₂.

8. A semiconductor device according to one of claims 1 to 7, wherein the edge termination region further comprises a continuous ring of the second conductivity type that laterally surrounds the plurality of inactive cells.

9. A semiconductor device according to claim 8, wherein the continuous ring of the second conductivity type is arranged laterally adjacent to a continuous trench that laterally surrounds the continuous ring and that comprises a field plate.

10. A semiconductor device according to one of claims 1 to 9, wherein each active transistor cell comprises a mesa and a columnar trench, and the mesa comprises the drift region, the body region arranged on the drift region, a source region of the first conductivity type arranged on the body region and a gate trench comprising a gate electrode.

11. A semiconductor device according to claim 10, wherein the columnar trench of each active transistor cell comprises a base, a side wall, a field plate, and a field dielectric arranged on the base and the side wall and surrounding the field plate, wherein the field dielectric has a first thickness in an upper region of the field plate and a second thickness in a lower region of the field plate, the first thickness being smaller than the second thickness.

12. A method for fabricating a semiconductor device, the method comprising:
forming a plurality of columnar trenches in a first major surface of a semiconductor substrate having a first conductivity type, the columnar trenches being arranged in an array of offset rows and each having a base and a side wall extending form the base to the first major surface;
lining the base and side wall of the columnar trenches with a field dielectric;
inserting conductive material into the columnar trenches;
whilst covering a second subset of the plurality of columnar trenches that lies laterally outboard of a first subset of the plurality of columnar trenches, in the first subset of trenches:
removing an upper portion of the conductive member from an upper portion of the columnar trenches and exposing the field dielectric arranged on the side wall;
removing a portion of the exposed field dielectric and reducing the thickness of the exposed field dielectric arranged on the side wall of the upper portion of the columnar trenches;
inserting conductive material into the columnar trench and filling the upper portion of the trench with the conductive material;
implanting dopants of a second conductivity type into a first predetermined area of the first major surface to form a body region, wherein the second subset of the plurality of columnar trenches is positioned laterally outboard of the first predetermined area and the first subset of the plurality of columnar trenches is positioned laterally within the first predetermined area;
implanting dopants of the first conductive type into a second predetermined area that is smaller than the first predetermined area.

13. A method according to claim 12, wherein an outer one of the first subset of the plurality of columnar trenches is positioned laterally outboard of the first predetermined area and in the second predetermined area, or, wherein an outermost one of the first subset of the plurality of columnar trenches is arranged laterally outboard of the second predetermined area.

14. A method according to claim 12 or claim 13, further comprising:
forming a continuous trench that laterally surrounds the array of columnar trenches, the continuous trench having a base and side walls;
implanting dopants of the second conductivity type into the side walls of the continuous trench over a first depth range from the first major surface.

15. A method according to claim 14, further comprising:
implanting dopants of the second conductivity type into the side walls of the continuous trench over a second depth range from the first major surface, wherein at least a part of the second depth range is vertically adjacent the first depth range.
